# EUROPÄISCHE PATENTSCHRIFT

(11) **EP 3 679 187 B1**
(45) Veröffentlichungstag und Bekanntmachung des Hinweises auf die Patenterteilung: **02.02.2022**
(21) Anmeldenummer: 17767786.1
(22) Anmeldetag: 08.09.2017
(51) Int. Cl.: D04H 1/42, D04H 1/4234, D04H 3/005, H05K 9/00

(54) **VLIES ZUR ABSCHIRMUNG VON TERAHERTZ FREQUENZEN**
NONWOVEN FABRIC FOR SHIELDING TERAHERTZ FREQUENCIES
NON-TISSÉ DESTINÉ AU BLINDAGE DE FRÉQUENCES TÉRAHERTZ

(43) Veröffentlichungstag der Anmeldung: 15.07.2020
(73) Patentinhaber: SZE Spezial Elektronik Hagenuk GmbH, 24145 Kiel (DE)
(72) Erfinder: VAN HATTUM, Edgar-Johannes, 29303 Bergen (DE)
(74) Vertreter: Prinz & Partner mbB
(86) Internationale Anmeldenummer: PCT/EP2017/072634
(87) Internationale Veröffentlichungsnummer: WO 2019/048056

(56) Entgegenhaltungen:
- CA-A1- 2 645 531
- DE-U1-202006 011 912
- JP-A- 2011 241 522
- US-A- 4 943 477
- US-A1- 2012 289 107

## Beschreibung

### GEBIET DER ERFINDUNG

Die vorliegende Erfindung betrifft ein Verfahren zur Herstellung eines Vlieses zur Abschirmung von elektromagentischer Strahlung, insbesondere von Frequenzen im Terahertz (THz)Bereich, insbesondere von 5 THz bis 300 THz, ein entsprechendes Vlies herstellbar nach dem erfindungsgemäßen Verfahren sowie Verwendungen des Vlieses.

### HINTERGRUND DER ERFINDUNG

Elektromagnetische Strahlung besteht aus gekoppelten elektrischen und magnetischen Feldern. Zu ihnen gehören unter anderem Radiowellen, Mikrowellen, Infrarotstrahlung, sichtbares Licht, UV-Strahlung sowie Röntgen- und Gammastrahlung.

Terahertz (THz) Strahlung ist eine elektromagnetische Strahlung mit einer Frequenz von ungefähr 10¹² Hertz. Im elektromagnetischen Spektrum ist die Terahertz-Strahlung zwischen dem sichtbaren Licht und der Mikrowellenregion angeordnet und wurde früher als fernes Infrarot bezeichnet.

Elektromagentische Wellen im TerahertzBereich sind eine nicht ionisierende elektromagnetische Strahlung (kurz: Terahertz-Strahlung bzw. TerahertzStrahlen oder auch Terahertz-Frequenzen). Nicht ionisierend bedeutet, dass die Energie eines Terahertzphotons zu klein ist, um Elektronen aus Atomen oder Molekülen zu entfernen.

Eine erhöhte Terahertz-Strahlung wird beispielsweise in Flugzeugen auf Flughöhe gemessen sowie im Bereich von Strommasten für Hoch- und Mittelspannung oder Transformatorenstationen, in denen die elektrische Energie aus dem Mittelspannungsnetz auf ein Niederspannungsnetz umgewandelt (transformiert) wird.

Derzeit können Terahertzstrahlen beispielsweise mittels Bleimaterialien, insbesondere Bleiwesten für Personen abgeschirmt werden. Diese Bleimaterialien weisen jedoch ein vergleichsweise hohes Eigengewicht auf und sind vergleichsweise starr und wenig atmungsaktiv.

US 2012/289107 offenbart ein Verfahren zur Herstellung eines Vlieses umfassend beschichteten, faserkernverfüllten Polymerfasern.

Es besteht nun die Aufgabe der vorliegenden Erfindung darin, geeignete Materialien für die Abschirmung von elektromagnetischer Strahlung, insbesondere von Terahertz-Strahlung bereitzustellen, wobei die Materialien leichter als Bleimaterialien zu verarbeiten sind und insbesondere ein vergleichsweise geringes Eigengewicht besitzen und/oder vergleichsweise flexibel und/oder atmungsaktiv sind.

### BESCHREIBUNG

Die vorgenannte Aufgabe wird anhand der erfindungsgemäß beanspruchten Gegenstände gelöst. Vorteilhafte Ausgestaltungen werden in den abhängigen Ansprüchen sowie in der nachfolgenden Beschreibung und den Figuren dargestellt.

Dementsprechend betrifft ein erster Erfindungsgegenstand der vorliegenden Erfindung ein Verfahren zur Herstellung eines Vlieses zur Abschirmung elektromagnetischer Strahlung (elektromagnetischer Wellen), insbesondere von Terahertz (THz)-Strahlung, insbesondere im Bereich von 5 THz bis 300 THz, umfassend oder bestehend aus einem in drei Dimensionsrichtungen (X, Y und Z) des Vlieses zufällig unregelmäßig angeordneten Netzwerk von beschichten, faserkernverfüllten Polymerfasern, dadurch gekennzeichnet, dass das Verfahren folgende Schritte umfasst oder daraus besteht:
a. Bereitstellen einer ersten Metalllegierung, die geeignet ist elektromagentische Strahlung, insbesondere im Terahertz (THz)- Bereich, insbesondere von 5 THz bis 300 THz abzuschirmen,
b. Bereitstellen eines Polymermaterials,
c. Bereitstellen einer zweiten Metalllegierung, die sich von der ersten Metalllegierung aus Schritt a) dadurch unterscheidet, dass ein Ladungspotentialunterschied zwischen der ersten und zweiten Metalllegierung hervorgerufen werden kann,
d. Herstellen von faserkernverfüllten Polymerfasern durch Verdampfen der ersten Metalllegierung aus Schritt a) zu ersten Metalllegierungsmolekülen mit trigonaler Struktur und Mischen der ersten Metalllegierungsmoleküle mit dem in Schritt b) bereitgestellten Polymermaterial sowie Anordnung des metallisierten Polymermaterials in Faserform, wobei die ersten Metalllegierungsmoleküle mit trigonaler Struktur im Wesentlichen im Kern der Polymerfaser angeordnet sind und ein Gitter bilden, in dem die einzelnen ersten Metalllegierungsmoleküle jeweils durch das Polymer isoliert vorliegen, aber die Elektronenwolken der benachbarten ersten Metalllegierungsmoleküle überlagern, und
e. Beschichten zumindest eines Teils der Oberfläche der faserkernverfüllten Polymerfasern aus Schritt d) mit der zweiten Metalllegierung aus Schritt c), wobei die zweite Metalllegierung zu einzelnen zweiten Metalllegierungsmolekülen mit hexa- oder oktagonale Struktur verdampft wird und diese isoliert von einander an der Polymerfaseroberfläche angeordnet sind und ein Oberflächen-Gitter bilden, in dem sich die Elektronenwolken der einzelnen zweiten Metalllegierungsmoleküle überlagern, und Herstellen des Vlieses durch zufällig unregelmäßiges Anordnen der beschichteten, faserkernverfüllten Polymerfasern in den drei orthogonalen räumlichen Dimensionsrichtungen (X, Y und Z) oder
f. Herstellen des Vlieses durch zufällig unregelmäßiges Anordnen der faserkernverfüllten Polymerfasern aus Schritt d) in den drei orthogonalen räumlichen Dimensionsrichtungen (X, Y und Z) und Beschichten zumindest eines Teils der Oberfläche des Vlieses mit der zweiten Metalllegierung aus Schritt c), wobei die zweite Metalllegierung zu einzelnen zweiten Metalllegierungsmolekülen mit hexa- oder oktagonale Struktur verdampft wird und diese isoliert von einander an der Polymerfaseroberfläche angeordnet sind und ein Oberflächen-Gitter bilden, in dem sich die Elektronenwolken der einzelnen zweiten Metalllegierungsmoleküle überlagern.

Ein zweiter Erfindungsgegenstand der vorliegenden Erfindung betrifft ein Vlies zur Abschirmung von elektromagnetischer Strahlung, insbesondere von Terahertz-Strahlung, insbesondere im Bereich von 5 THz bis 300 THz, herstellbar gemäß dem erfindungsgemäßen Verfahren.

Ein dritter Erfindungsgegenstand der vorliegenden Erfindung betrifft eine Verwendung des erfindungsgemäßen Vlieses zur Abschirmung von elektromagnetischer Strahlung, insbesondere Terahertz-Strahlung, insbesondere im Bereich von 5 THz bis 300 THz.

Ein vierter Erfindungsgegenstand der vorliegenden Erfindung betrifft eine Verwendung des erfindungsgemäßen Vlieses zur Herstellung von menschlichen oder tierischen Schutzanzügen.

Ein fünfter Erfindungsgegenstand der vorliegenden Erfindung betrifft eine Verwendung des erfindungsgemäßen Vlieses zur Abschirmung von Gebäuden, Fahrzeugen (zu Land, zu Wasser und/oder zu Luft), Gegenständen und Leitungen.

Ein vierter Erfindungsgegenstand der vorliegenden Erfindung betrifft eine Verwendung des erfindungsgemäßen Vlieses zur Herstellung von Polymerisolierungen von Öffnungen in Gebäuden oder Fahrzeugen (zu Land, zu Wasser und/oder zu Luft) oder Leitungen.

Die vorstehend beschriebenen Erfindungsgegenstände können, sofern aus Sicht eines Fachmannes sinnvoll, jede mögliche Merkmalskombination der bevorzugten erfindungsgemäßen Ausgestaltungen, die nachfolgend und insbesondere auch in den abhängigen Ansprüchen offenbart werden, aufweisen.

### BESCHREIBUNG DER FIGUREN

Im Folgenden werden die Merkmale und Aspekte der Erfindung anhand von Ausführungsbeispielen und unter Bezugnahme auf die Figuren näher erläutert, dabei zeigt:
- FIG. 1: eine vereinfachte Darstellung einer Faser eines Vlieses in perspektivischer Ansicht mit Schnittansicht durch die Faser gemäß einem Ausführungsbeispiel
- FIG. 2: eine Draufsicht auf ein Vlies gemäß einem Ausführungsbeispiel,
- FIG. 3: eine seitliche Schnittansicht eines Vlieses gemäß einem Ausführungsbeispiel, und
- FIG. 4: ein Ausführungsbeispiel mit mehreren Schichten eines Vlieses gemäß einem Ausführungsbeispiel.

### DETAILLIERTE BESCHREIBUNG

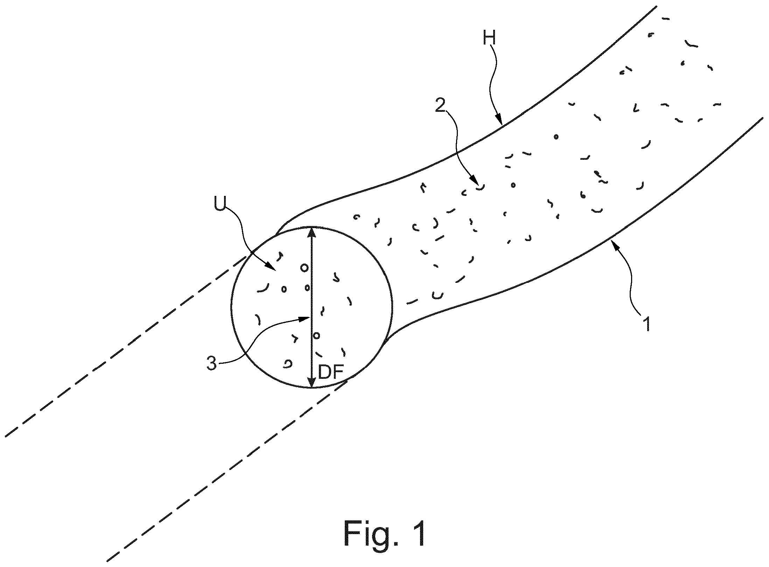

FIG. 1 ist eine vereinfachte Darstellung einer Faser bzw. Polymerfaser 1 eines erfindungsgemäßen Vlieses 4 in perspektivischer Ansicht mit Schnittansicht durch die Faser 1 gemäß einem Ausführungsbeispiel. Die Faser hat eine Länge L und einen Durchmesser DF. Auf der Oberfläche H der Faser 1 sind zweite Metalllegierungsmoleküle 2 angeordnet. Im Kern (oder einfach im Inneren) K der Faser 1 sind erste Metalllegierungsmoleküle 3 angeordnet.

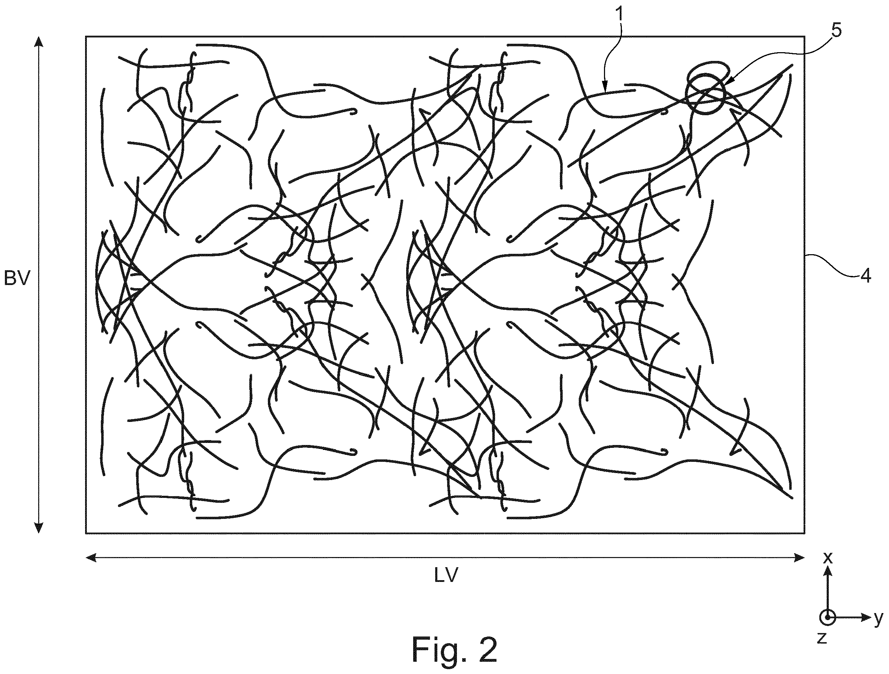

FIG. 2 ist eine Draufsicht auf ein erfindungsgemäßes Vlies 4 gemäß einem Ausführungsbeispiel. Das erfindungsgemäße Vlies 4 besteht aus zufällig unregelmäßig angeordneten Fasern 1, wie bspw. in FIG. 1 gezeigt. Die Fasern 1 erstrecken sich unregelmäßig in allen drei Raumrichtungen X, Y und Z. Die Fasern 1 können eine oder mehrere Krümmungen in eine oder mehrere der Raumrichtungen X, Y und Z aufweisen. Die Fasern 1 können miteinander an Kreuzungspunkten bzw. Verbindungspunkten 5 verbunden sein. Ein solcher Verbindungspunkt 5 ist exemplarisch mit einem Kreis hervorgehoben. Es ist auch vorstellbar, dass die Fasern 1 lediglich miteinander unregelmäßig und zufällig verschlungen sind und sich an den Kreuzungspunkten lediglich berühren. Das Vlies kann eine Länge LV in Y-Richtung, eine Breite BV in X-Richtung und eine Höhe bzw. Stärke oder Dicke (Schichtdicke) DV in Z-Richtung (hier nicht dargestellt) aufweisen. Insgesamt hat das erfindungsgemäße Vlies 4 eine Länge LV und eine Breite BV, die typischerweise wesentlich größer ist als die Dicke DV. So ergibt sich, dass das erfindungsgemäße Vlies 4 gegebenenfalls durch weitere übliche Verfestigungsschritte zu einer im Wesentlichen flachen Textile geformt wird, die für Anwendungen am menschlichen oder tierischen Körper, an oder in Fahrzeugen (zu Land, zu Wasser und/oder zu Luft), an oder in Gebäuden usw. einsetzbar ist.

Gemäß der vorliegenden Erfindung umfasst der Begriff Fahrzeuge jegliche Fortbewegungsmittel zu Land, zu Wasser und/oder zu Luft. Mit anderen Worten umfassen Landfahrzeuge insbesondere Kraftfahrzeuge, wie beispielsweise Automobile, Lastkraftwagen, Motorräder, oder auch Fahrräder, etc.. Wasserfahrzeuge umfassen motorisierte und auch nicht motorisierte Fahrzeuge, wie beispielsweise Schiffe, Boote, Jetski, Surfboards, etc.. Luftfahrzeuge umfassen motorisierte als auch nicht motorisierte Fahrzeuge, wie Flugzeuge, Hubschrauber, Luftschiffe (Zeppeline), Fahrgastballons, etc.. Die Fahrzeuge können sich bemannt oder autonom fortbewegen.

Der Begriff "Vlies" bzw. "Vliesmaterial" 4 bezeichnet in Bezug auf die vorliegende Erfindung allgemein einen Vliesstoff (englisch "non-woven") und ist ein Gebilde aus Fasern 1 begrenzter Länge, Endlosfasern (Filamenten) oder geschnittenen Fasern 1, die auf eine geeignete Weise zu einem Vlies 4 (einer Faserschicht, einem Faserflor) jeweils zusammengefügt worden sind. Der Begriff "Vlies" 4 bezeichnet in Bezug auf die vorliegende Erfindung sowohl unverfestigten Vlies (auch "Faservlies" genannt) als auch verfestigten Vlies (auch "Vliesstoffe" genannt). Hierbei gilt grundsätzlich folgende Beziehung: je höher der Verfestigungsgrad des Vlieses, desto kleiner die Lücken zwischen den Fasern, desto besser ist die Abschirmung von höherfrequenten Strahlen, insbesondere im Terahertz-Bereich. Bevorzugt handelt es sich bei dem erfindungsgemäßen Vlies 4 um ein mittels üblicher Verfahren verfestigtes Vlies bzw. einen verfestigten Vliesstoff, um Terahertz-Strahlung abzuschirmen. Davon nur insoweit zu unterscheiden, als die hierin beschriebenen Effekte, wenn auch verschlechtert, dennoch erreicht werden, ist das Verkreuzen bzw. Verschlingen von Garnen, wie es beim Weben, Wirken, Stricken, der Spitzenherstellung, dem Flechten und Herstellung von getufteten Erzeugnissen geschieht.

Im Vordergrund für die vorliegende Erfindung steht die zufällige unregelmäßige Anordnung und Erstreckung der Fasern 1 im Raum X, Y und Z.

Das erfindungsgemäße Vlies 4, welches die Polymerfasern 1 umfasst, ist beispielsweise ein größtenteils flexibles textiles Flächengebilde, d. h. es ist leicht biegsam. Im vorliegenden Fall besteht das erfindungsgemäße Vlies 4 zumindest überwiegend, ggf. auch ausschließlich aus den Polymerfasern 1, die eine vergleichsweise geringe Dicke gegenüber ihrer Länge und Breite aufweisen. Allerdings können auch erfindungsgemäße Vliese 4 mit einer verhältnismäßig großen Dicke hergestellt werden, die räumlichen Gebilden zugeordnet werden müssen (z. B. Vliesstoffe für Dämmstoffe und Polstermaterialien). Auch für derartige Anwendungen ist die vorliegende Erfindung geeignet. Alternativ oder kumulativ können zwei, drei oder mehrere erfindungsgemäße Vliese 4 je nach Verwendung übereinander angeordnet werden bzw. ein Vlies 4 mehrfach gefaltet werden, um eine geeignete Abschirmung für eine entsprechende magnetische Strahlung zu erreichen.

Das erfindungsgemäße Vlies kann gemäß üblicher Herstellverfahren für Vliesmaterialien gebildet werden. Eine Unterteilung der erfindungsgemäß geeigneten Herstellverfahren ist Deutsche Institut für Normung e.V. (DIN) Norm 61 210 zu entnehmen.

Dementsprechend sind mechanisch gebildete Vliese für die vorliegende Erfindung geeignet, die aus von Karden oder Krempeln abgenommenen Floren hergestellt werden, die zu Vliesen übereinandergelegt werden, oder direkt von diesen Kardiermaschinen gebildet werden. Es handelt sich dabei generell um Vliese aus Spinnfasern.

Alternativ sind erfindungsgemäß auch aerodynamisch gebildete Vliese für die vorliegende Erfindung geeignet, die aus Fasern mittels eines Luftstromes auf einer luftdurchlässigen Unterlage gebildet werden. Werden die Vliese aus Spinnfasern oder auch Kurzschnittfasern sowie Flockzellstoff gebildet, werden sie als Trockenvliese bezeichnet. Es entstehen generell Wirrlagevliese und nach entsprechender Verfestigung Trockenvliesstoffe oder Wirrlagevliesstoffe.

Alternativ sind erfindungsgemäß auch Vliese geeignet, die aus Fasern bestehen, die direkt aus durch Düsen hindurchtretende Polymerschmelzen ersponnen werden.

Werden die aus durch Düsen hindurchtretende Polymerschmelzen ersponnen Fasern mittels heißer Luftströme bis zum Zerreißen verstreckt und durch unmittelbares Ablegen gebildet, entstehen sogenannte Schmelz-Blas-Vliese bzw. Meltblown-Vliese. Sie bestehen meist aus längeren Spinnfaser ähnlichen Endlosfaserabschnitten, aber auch aus einer Mischung mit Endlosfasern oder vollständig aus Endlosfasern. Die darauf aufbauenden verfestigten Vliese werden meist als Meltblown-Vliesstoffe bezeichnet.

Werden die aus durch Düsen hindurchtretenden Polymerschmelzen ersponnen Fasern mittels kalter Luft und/oder mechanisch verstreckt und durch unmittelbares Ablegen gebildet, bezeichnet man sie als Spinnvliese bzw. nach der Verfestigung als Spinnvliesstoffe (Spunlaid bzw. Spunbond Vlies / Vliesstoff) Die Vliese bauen sich dabei ausschließlich aus Filamenten bzw. Endlosfasern auf.

Alternativ können Meltblown-Vliese im schichtenweisen Verbund mit Spinnvliesen hergestellt werden, es entstehen so zum Beispiel Spinnvlies-Meltblownvlies-Spinnvlies (SMS). Diese erhalten durch den schichtweisen Aufbau eine höhere Festigkeit gegenüber den Einzelfaservliesen.

Alternativ sind auch hydrodynamisch gebildete Vliese für die vorliegende Erfindung geeignet. Bei hydrodynamisch gebildeten Vliesen werden die Fasern in Wasser aufgeschwemmt und auf einer wasserdurchlässigen Unterlage abgelegt. Werden kürzere Spinnfasern, aber auch Flockzellstoff verwendet, bezeichnet man die Vliese als Nassvliese. Die anschließend verfestigten Vliese als Nassvliesstoffe. Das Verfahren wird auch häufig als Nassverfahren bezeichnet. Wenn Endlosfasern, die direkt aus Polymerlösungen ersponnen, gegebenenfalls verstreckt werden, mittel Wasser zu einem Vlies abgelegt werden, erhält man Nass-Spinnvliese bzw. in verfestigter Form Nass-Spinnvliesstoffe.

Erfindungsgemäße geeignet sind ebenfalls elektrostatisch gebildete Vliese, deren Fasern aus Polymerlösungen oder -schmelzen unter Einwirkung eines elektrischen Feldes gebildet und abgelegt werden. Es entstehen sogenannte Feinstfaservliese oder Nanofaservliese.

Gemäß der vorliegenden Erfindung können auch Kombinationen der vorstehenden Vliesherstellungen verwendet werden. Erfindungsgemäß besonders bevorzugt ist die Kombination einer Spinnvlies- mit einer elektrostatischen Herstellung. Hierbei wird das metallisierte Polymermaterial vorzugsweise tropfenförmig in ein elektrisches Feld gebracht und während Zufuhr eines gegenüber dem Polymermaterial kälteren, vorzugsweise sauerstofffreien Gases zu einer Polymerfaser 1 gezogen. Vorteilhaft an der Kombination ist, dass durch das E-spinning eine Faser 1 hergestellt wird, in dem die ersten Metalllegierungsmoleküle 3 vorwiegend im Innern der Faser 1 angeordnet sind und durch kältere, vorzugsweise sauerstofffreie Gaszufuhr die Polymerfaser 1 entsprechend abgekühlt und erstarrt wird.

Eine alternative häufig verwendete Unterteilung der erfindungsgemäß geeigneten Vliesbildungsverfahren betrifft die Unterteilung in Trocken-, Nass- und Extrusionsverfahren.

Hierbei werden die vorgenannten mechanischen und aerodynamischen Vliesbildungsverfahren auf Spinnfaserbasis dem Trockenverfahren zugeordnet.

Das hydrodynamische Vliesbildungsverfahren auf Spinnfaserbasis wird dem Nassverfahren zugeordnet.

Den Extrusionsverfahren zur Vliesbildung wurden anfänglich nur solche Vliesbildungsverfahren zugeordnet, die auf Polymerschmelzen beruhen, Schmelz-Blas-(Meltblown)-Vliese und Spinnvliese aus Endlosfasern, die Bildung von Feinstvliesen durch Elektrospinnen und von Foliefaservliesen, die durch Fibrillierung von extrudierten Folien erzeugt werden. Die Extrusionsvliese umfassen in neueren Systematiken auch eine Vliesbildung direkt aus Polymerlösungen gebildeten Fasern nach dem Elektrostatikspinnverfahren oder dem sogenannten Flash-Spinning-Verfahren (Entspannungsverdampfungs-Spinnvliesverfahren).

Die erfindungsgemäß bevorzugte Kombination aus Extrusionsverfahren und Elektrostatikspinnverfahren wird auch dem Nassverfahren zugeordnet.

Üblicherweise wird das hergestellte Faservlies mechanisch, chemisch und /oder thermisch verfestigt, wobei ein anschließend ein festerer Verbund zwischen den Fasern gegenüber dem ursprünglich hergestellten Faservlies vorliegt. Durch eine entsprechende Verfestigung wird der Abstand der Polymerfasern 1 im Vlies verringert. Je kleiner der Abstand bzw. Lücken zwischen den Fasern, desto höher der Abschirmeffekt auch für höherfrequente Strahlung, insbesondere Terahertzstrahlung sowie noch höherfrequente Strahlung.

Bei den mechanischen Verfestigungsverfahren wird der Verbund der Fasern durch Reibschluss oder durch eine Kombination von Reib- und Formschluss hergestellt. Bei der Reibschluss-Bindung wird durch eine Vliesverdichtung der Abstand der benachbarten Fasern gegenüber dem im Vlies verringert. Damit wird die Haftung der Fasern aneinander erhöht und es können höhere Kräfte übertragen werden. Der Widerstand des Vlieses gegen Verformung wird höher, es wird fester.

Erreicht werden kann die Verdichtung alternativ durch Schrumpfen aller Fasern oder eines Anteils, wenn die Fasern schrumpffähig bei Einwirkung von Wärme und/oder einem Quellmittel sind. Es entstehen Schrumpfvliesstoffe oder Quellvliesstoffe.

Ebenso kann das Verdichten durch Pressen (meistens Kalandern) erreicht werden. Gemäß einer Ausführungsform der vorliegenden Erfindung wird das erfindungsgemäße Vlies durch eine Rollsystem gepresst, wobei Kräfte von größer gleich 0,1 bar, bevorzugt größer gleich, 0,2 bar, 0,3 bar, 0,4 bar, 0,5 bar, 0,6 bar, 0,7 bar, 0,8 bar, 0,9 bar, 1,0 bar, 1,1 bar, 1,2 bar, 1,3 bar, 1,4 bar, 1,5 barm 1,6 bar, 1,7 bar, 1,8 bar oder mehr verfestigt werden. Gemäß einer bevorzugten Ausgestaltung wird dieses Rollsystem mit einem Heizsystem kombiniert, sodass das verfestigte Vlies gleichzeitig getrocknet wird. Vorzugsweise wird das Rollsystem auf Temperaturen bis unter 70 °C, vorzugsweise im Bereich zwischen 40 °C und 65 °C beheizt. Das erfindungsgemäß verfestigte Vlies weist vorzugsweise einen Feuchtigkeitsanteil von ≤ 20 %, weiter bevorzugt ≤ 10 % auf.

Alternativ kann die mechanische Verfestigung durch Walken erfolgen, bei welchem die Fasern des Vlieses filzfähig sein müssen und durch gleichzeitige thermische, chemische und mechanische Einwirkungen untereinander verfilzen. Durch das Walken entstehen Filze bzw. Walkvliesstoffe.

Nadelvliesstoffe, bei denen das Verschlingen der Fasern und damit das Verdichten und Verfestigen des Vlieses durch Vernadeln erfolgt, in dem eine Vielzahl von speziellen, in einem Nadelbrett oder -balken angeordneten Nadeln (Widerhakennadeln, Gabelnadeln) ein- und ausgestochen wird, sind erfindungsgemäß weniger geeignet, das aufgrund dieser Vernadelung gleichmäßige Löcher und damit Lücken in das Vlies eingebracht werden, welche die Abschirmwirkung abschwächen können.

Die erfindungsgemäßen Vliese können alternativ oder kumulativ durch chemische Verfestigungsverfahren verfestigt werden, wodurch der Verbund der Fasern durch Stoffschluss mittels Zusatzstoffen hergestellt wird (synonym "adhäsive Bindung"). Allerdings wird eine solche chemische Verfestigung erfindungsgemäß eher nicht angewendet, da das Bindemittel selbst keine Wirkung bei der Abschirmung zeigt und durch die zusätzlichen Bindemittel größere Abstände zwischen den Metallegierungsmolekülen gebildet werden können und so die Abschirmwirkung reduziert werden kann.

Bei den thermischen Verfestigungsverfahren für erfindungsgemäße Vliese wird der Verbund der Fasern ebenfalls durch Stoffschluss hergestellt, wobei oft noch zwischen adhäsivem und kohäsiven Verbund unterschieden wird. Voraussetzungen sind thermoplastische Zusatzkomponenten oder thermoplastische Fasern. Bei der adhäsiven Verfestigung werden dem Vlies Bindemittel in fester Form als Faser (Einkomponentenfaser mit niedrigerem Schmelzpunkt als Hauptkomponentfaser oder Bi- bzw. Mehrkomponentenfaser, wobei eine Komponente vorzugsweise diejenige an der Oberfläche der Faser einen niedrigeren Schmelzpunkt als die anderen Komponenten aufweist. Durch eine thermische Behandlung, z. B. durch Heißluftdurchströmung (Thermofusion) oder Thermokalandrieren mittels gravierten und/oder glatten Walzen, bei dem neben der Wärme gleichzeitig Druck einwirkt, wird das thermische Bindemittel in einen klebrig-flüssigen Zustand gebracht, so dass es eine feste Bindung mit der Hauptfaserkomponenten des Vlieses eingeht.

Bei der kohäsiven Verfestigung werden rohstoffgleiche, thermoplastische Fasern ohne ein zusätzliches Bindemittel miteinander zu erfindungsgemäßen Vliesen gebunden. Es erfolgt ein Verschweißen der Fasern, in dem sie durch zeitweiliges Einwirken einer erhöhten Temperatur erweichen und sich die benachbarten Fasern an den Berührungspunkten verbinden. Sehr häufig erfolgt die Verbindung unter gleichzeitiger Druckeinwirkung. Eine kohäsive Verfestigung ist vorzugsweise dann geeignet, wenn leichte Faservliese bzw. leichte Spinnvliese beispielsweise durch beheizte Prägekalander, aber auch durch Ultraschall-Schweißanlagen verfestigt werden.

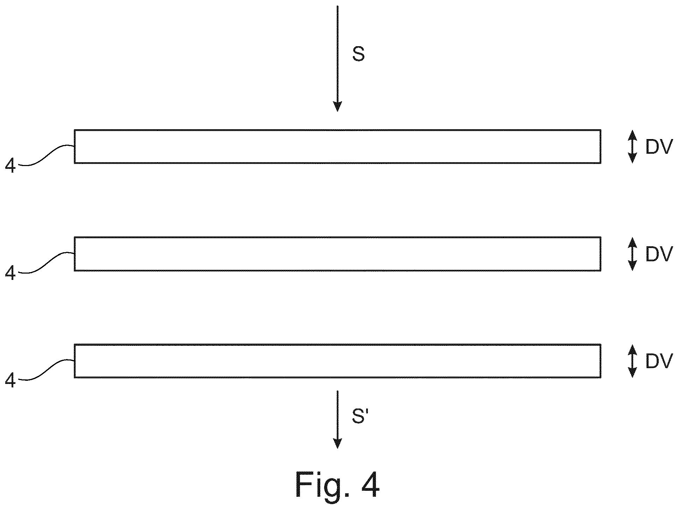

Während die einzelnen Polymerfasern 1 im erfindungsgemäßen Vlies 4 im Mikrometermaßstab in X, Y und Z Richtung des Raumes zufällig und inhomogen bzw. ungleichmäßig angeordnet sind, bildet das erfindungsgemäße Vlies als Ganzes in dreidimensonaler Sicht ein homogenes Faserkonstrukt. Treffen elektromagnetische Strahlen/Wellen auf das erfindungsgemäße Vliesmaterial auf, bilden sich zwar zunächst im Mikrometermaßstab statische Felder (positive und negative Ladungen in den Fasern) aus, diese heben sich aber im Dezimetermaßstab verteilt über das gesamte Vlies annähernd vollständig auf. Mit anderen Worten sollte das Vlies 4 in Durchgangsrichtung (vgl. unten FIG. 4 Referenzvektor S), also senkrecht zur Erstreckungsebene des Vlieses 4, keine oder nur solche Durchgangsöffnungen aufweisen, die im Verhältnis zur Wellenlänge, der zu absorbierenden Strahlung sehr klein sind. Beispielsweise, wäre dies bei 5 THz eine Wellenlänge λ von 0.2 mm bzw. 200 µm. Entsprechend sollte ein geeignetes Vlies vorteilhaft keine durchgehenden Öffnungen aufweisen, die in der Größenordnung der Wellenlänge der zu absorbierenden Strahlung liegen. Im vorliegenden Beispiel (5 THz) sollte der maximale Durchmesser DO (nicht gezeigt) einer durchgehenden Öffnung sehr viel kleiner sein als die Wellenlänge λ der zu absorbierenden Strahlung, also DO « λ bzw. DO « 0.2 mm. Bei höheren Frequenzen sind die Wellenlängen entsprechend kürzer, was bedeutet, dass das Vlieses entsprechend dichter sein muss. Ferner sollten das Vlies auch Abstände AK der Kontaktpunkte zwischen den Fasern 1 aufweisen, die gegenüber der Wellenlänge λ der zu absorbierenden Strahlung klein sind (AK <<λ). Für einen Frequenzbereich von 5 THz bis 300 THz gilt somit das DO, AK << 3.3 µm sein sollten. Vorteilhaft kann das Vlies so verdichtet werden bzw. aufgebaut sein, dass praktisch keine Durchgangsöffnungen vorliegen und die Kontaktpunkte zwischen den Fasern sehr dicht liegen. Damit ist das Vlies ggf. auch für elektromagnetische Strahlung in sehr viel höheren Frequenzbereichen geeignet.

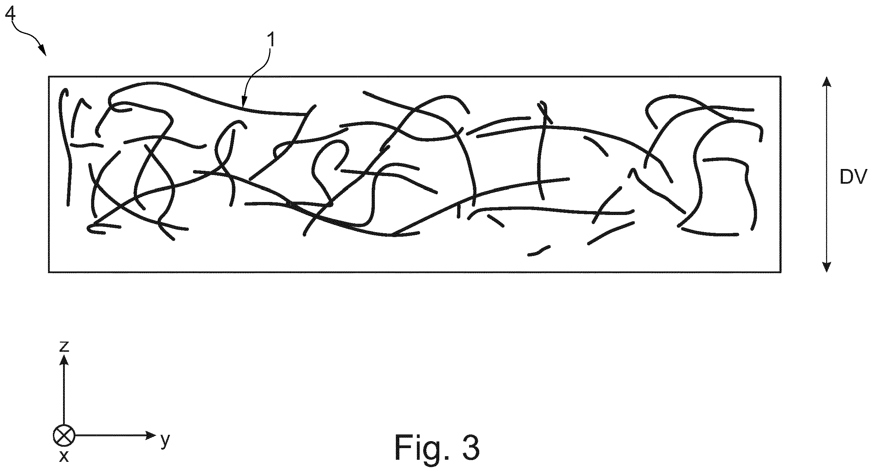

FIG. 3 ist eine seitliche Schnittansicht eines erfindungsgemäßen Vlieses 4 gemäß einem Ausführungsbeispiel. Es kann sich um das erfindungsgemäße Vlies 4 aus FIG. 2 handeln. Auch hier ist zu sehen, wie sich die Fasern 1 unregelmäßig in allen drei Raumrichtungen X, Y und Z erstrecken. Die Länge L der erfindungsgemäßen Fasern 1 kann im Wesentlichen gleich oder unterschiedlich sein. In dieser Darstellung ist nur die Dicke DV zu erkennen.

FIG. 4 ist ein Ausführungsbeispiel mit mehreren Schichten (Sandwichstruktur) eines erfindungsgemäßen Vlieses 4 gemäß einer Ausführungsform. Wenn das erfindungsgemäße Vlies 4 in mehreren Lagen (hier bspw. 3 Lagen, alternativ sind 2, 4, 5, 6, 7, 8, 9, 10 oder mehr Lagen möglich) übereinander und ggf. beabstandet voneinander angeordnet wird, kann die Dämpfungswirkung noch erhöht werden. Die einfallende elektromagentische Strahlung S wird dann um einen Faktor gedämpft und kommt auf der gegenüberliegenden Seite des erfindungsgemäßen Vlieses 4 umfassend die Sandwichanordnung aus mehreren Vlies-Lagen nur noch als elektromagentische Strahlung S' an.

Die vorliegende Erfindung beruht unter anderem auf der überraschenden Erkenntnis, dass das erfindungsgemäße Vliesmaterial 4 für elektromagnetische Strahlung, insbesondere für Terahertz-Strahlung im Bereich von 5 THz bis 300 THz eine Schirmdämpfung von ≥ 10 % zeigt. Vorzugsweise liegt bei 30 THz eine Schirmdämpfung von ≥ 70 %, weiter bevorzugt ≥ 80 %, noch weiter bevorzugt ≥ 90 % vor, während bei 300 THz eine Schirmdämpfung von ≥ 15 %, bevorzugt ≥ 20 % vorliegt. Das erfindungsgemäße Vlies 4 weist für Terahertz-Strahlung im Bereich 5 THz bis 300 THz einen Dämpfungswert von ≥ 100 Dezibel (dB), bevorzugt 120 Dezibel (dB) auf.

Darüber hinaus kann auch elektromagnetische Strahlung in deutlich niedrigeren oder höheren Frequenzbereichen absorbiert und damit abgeschirmt werden. Hierbei gilt grundsätzlich: je dünner die Polymerfasern 1, desto kleiner die Öffnungen zwischen den Polymerfasern 1 und desto stärker die Abschirmwirkung auch für höherfrequente Strahlung.

Gleichzeitig ist das erfindungsgemäße Vliesmaterial 4 vorteilhaft, weil es im Vergleich zu herkömmlichen für die Abschirmung verwendeten Bleimaterialien ein niedrigeres Materialgewicht aufweist und dennoch druck- und zugstabil ist.

Darüber hinaus ist das erfindungsgemäße Vliesmaterial 4 aufgrund der Vliesstruktur flexibel und gleichzeitig atmungsaktiv.

Nach derzeitigem Kenntnisstand geht man davon aus, dass die auf der Ebene der Oberfläche des erfindungsgemäßen Vlieses 4 eintreffende elektromagnetische Strahlung, insbesondere Terahertz-Strahlung durch die zweiten Metalllegierungsmoleküle 2, die auf der Oberfläche der Polymerfasern 1 ein Gitter bilden, absorbiert werden. Bei der Absorption der elektromagentischen Strahlung durch die zweite Metalllegierungsmoleküle 2 im Oberflächen-Gitter entsteht durch Konvektion eine statische Ladung. Diese wird aufgrund des Ladungspotentialunterschieds zwischen der zweiten 2 und der ersten Metalllegierung 3 in die Tiefe (Z-Achse) des Vlieses 4 gezogen. Die ersten Metalllegierungsmoleküle 3 im Gitter des Faserkerns K verarbeiten die entstandene Ladung schneller als die zweiten Metalllegierungsmoleküle 2 auf der Oberfläche und leiten die durch die elektromagnetischen Wellen entstandenen Ladungen als konvektionsartigen Strom im Kern K weiter. Hierdurch entstehen generell entgegengesetzte Ladungen bzw. Potentiale im Mikrometermaßstab. Aufgrund der im Mirkometermaßstab zufälligen, unregelmäßigen Anordnung der faserkernverfüllten Polymerfasern 1 im erfindungsgemäßen Vlies 4 schwächen sich die gegensätzlichen Ladungen bzw. die damit verbundenen lokalen Potentiale im Dezimetermaßstab annähernd vollständig ab. Bei dem erfindungsgemäßen Vlies konnte eine entsprechende Abschwächung der Ladungen / Potentiale (Potentialaufhebung) von > 98 %, insbesondere < 99 % gemessen werden. Es entsteht somit keine Oberflächenspannung und eine Reflektion an elektromagnetischer Strahlung / Frequenz kann erfindungsgemäß vermieden werden.

Gemäß dem ersten Erfindungsgegenstand werden erste Metalllegierungen 3 und zweite Metalllegierungen 2 bereitgestellt. Vorzugsweise liegen diese in Pulverform vor. Die Partikel des Pulvers haben einen mittleren Partikeldurchmesser im µm-Bereich, weiter bevorzugt einen mittleren Partikeldurchmesser im Bereich von ≤ 100 µm, weiter bevorzugt ≤ 50 µm, noch weiter bevorzugt ≤ 20 µm.

Gemäß allen Erfindungsgegenständen der vorliegenden Erfindung umfasst die erste Metalllegierung 3 aus Schritt a) und/oder die zweite Metalllegierung 2 aus Schritt c) vorzugsweise ein, zwei, drei oder mehrere unterschiedliche Metalllegierungen.

Hierbei ist eine erste Metalllegierung 3 erfindungsgemäß bevorzugt, wobei die Metalle der ersten Metalllegierung(en) 3 aus Schritt a) des ersten Erfindungsgegenstandes aus zwei, drei, vier oder mehreren Metallen ausgewählt werden aus der Gruppe bestehend aus Blei (Pb), Titan (Ti), Paladium (Pd), Praeseodym (Pr), Lanthan (La), Indium (In), Kobalt (Co), Aluminium (Al), Chrom (Cr), Nickel (Ni), Molybdän (Mo), Barium (Ba), Yttrium (Y), Samarium (Sm), Silizium (Si), Germanium (Ge) und Eisen (Fe).

Beispielsweise kann die erste Metalllegierung 3 aus Schritt a) ausgewählt werden aus der Gruppe bestehend aus Kobalt-Legierungen, beispielsweise Co_{68.7}Fe₄Ni₁B₁₃Si₁₁Mo_{2.3}, Nd₃Fe₆₈₋ₓMnₓCo₁₈B₁₁ (x = 0, 1, 2) oder CoFe₂; Paladium-Legierungen, vorzugsweise Paladium-Indium-Eisen Legierungen, beispielsweise Pd₅₇In₂₅Fe₁₈, und Pd_{56.2}In_{26.3}Fe_{17.5}; vorzugsweise Titan-Paladium-Eisen Legierungen, beispielsweise Ti₅₀Pd₄₀Fe₁₀, und Ti₅₀Pd₃₅Fe₁₅; vorzugsweise Paladium-Mangan-Indium Legierungen, beispielsweise Pd₂MnIn; Manganat-Legierungen, beispielsweise Praseodym-Lanthan-Calcium-Manganat Legierungen wie Praseodym-Calcium-Manganat Legierungen oder Lanthan-Calcium-Manganat Legierungen, wie beispielsweise Pr_{0.7}Ca_{0.3}MnO₃ oder La_{0.7}Ca_{0.3}MnO₃; Neodym-Blei-Manganat Legierungen wie Nd_{0.5}Pb_{0.5}MnO₃, Lanthan-Barium-Manganat Legierungen wie La_{2/3}Ba_{1/3}MnO₃; Bor-Kupfer Legierungen wie B₂CuO₂; Legierungen mit hohem Wolframanteil wie Barium-Yttrium-Kupfer-Wolfram Legierungen und Kupfer-Samarium-Wolfram Legierungen und Eisenlegierungen, wie FeNiMo, Fe₈₅Si_{3.5}Al_{5.5}Cr₆ und FeMnW-(P_{0,5}Ge_{0,1}Pb _{0,4}W_{0,2}).

Die zweite Metalllegierung 2 ist erfindungsgemäß dann bevorzugt, wenn die Metalle der zweiten Metalllegierung(en) 2 aus Schritt c) aus zwei, drei, vier oder mehreren Metalle ausgewählt werden aus der Gruppe bestehend aus Eisen (Fe), Mangan (Mn), Kupfer (Cu), Zink (Zn), Wolfram (W), Silicium (Si), Silber (Ag) und Zinn (Sn).

Beispielsweise kann die zweite Metalllegierung 2 aus Schritt c) ausgewählt werden aus der Gruppe bestehend aus Mangan Legierungen, vorzugsweise Nickel-Mangan-Zinn Legierungen, beispielsweise Ni₂Mn_{1.44}Sn_{0.56}, und Ni₂Mn_{1.42}Sn_{0.58}; vorzugsweise Nickel-Mangan-Gallium Legierungen, beispielsweise Ni₂MnGa; vorzugsweise Eisen-Mangan-Silicium Legierungen, beispielsweise FeMnSi, Fe_{57.4}Mn₃₅Si_{7.6}, Fe_{66.7}Mn_{28.8}Si_{6.5} und FeMnW-(P_{0,5}Ge_{0,1}Pb_{0,4}W_{0,2}) sowie Silber-Magnesium Legierungen, beispielsweise Ag-MgF₂-Ag.

Gemäß einer kumulativ oder alternativ bevorzugten Ausgestaltung der vorliegenden Erfindung werden die erste(n) Metalllegierung(en) 3 aus Schritt a) und gegebenenfalls die zweite(n) Metalllegierung(en) 2 und Schritt c) vorzugsweise so gewählt, dass sie sauerstofffrei sind. Für diese Ausgestaltung kann beispielsweise Phosphor (P) verwendet werden, um eine sauerstofffreie Metalllegierung bereit zu stellen.

Im Rahmen der vorliegenden Erfindung kann das Polymermaterial, bspw. für die Fasern 1 oder auch Pellets oder andere Ausgestaltungen aus Schritt b) des ersten Erfindungsgegenstands aus üblichen Polymermaterialien ausgewählt werden. Hierbei eignen sich insbesondere solche Polymermaterialien, welche eine Temperaturbeständigkeit von bis zu 95 °C aufweisen. Je nach Einsatzzweck können die Polymermaterialien ausgewählt werden aus der Liste bestehend aus der Gruppe der Polyester, beispielsweise Polyethylenterephthalat (PET), und der Gruppe der Polyamide, beispielsweise Poly(*p*-phenylenterephthalamid) (PPTA) und Poly(*m*-phenylenisophthalamid) (PMPI). Hierbei werden Polyester, wie PET vorzugsweise dann verwendet, wenn es sich um weichere Materialien handeln soll, während Polyamide gewählt werden, um härtete Vliesmaterialeigenschaften zu erreichen. Um ein Mischen des Polymermaterials mit den ersten Metalllegierungsmolekülen 3 zu erleichtern, werden dem Polymermaterial vorzugsweise geeignete Mittel zur Viskositätserniedrigung zugesetzt. Die geeignete Viskosität hängt von der Mischmethode ab. Beispielsweise werden für Polyester üblicherweise Alkohole, vorzugsweise hochzyklische Alkohole, wie beispielsweise C5 bis C9- Alkohole verwendet. Je höherzyklisch der Alkohol, desto viskoser die Zusammensetzung. Vorzugsweise kann erfindungsgemäß ein C6- oder C7-, vorzugsweise C6-Alkohol verwendet werden. Bei Polyamiden werden üblicherweise geeignete Säuren als viskositätserniedrigendes Mittel verwendet, vorzugsweise Ameisensäure.

Gemäß einer Ausführungsform der vorliegenden Erfindung können für die Herstellung der ersten Metalllegierungsmoleküle 3 in Schritt d) und / oder der zweiten Metalllegierungsmoleküle 2 in Schritt e) übliche physikalische Gasphasenabscheidungsverfahren verwendet werden, vorzugsweise (i) mittels Verdampfen, beispielsweise mittels thermischen Verdampfens, Elektronenstrahlverdampfen, Laserstrahlverdampfen, Lichtbogenverdampfen oder Molekularstrahlepitaxie, oder (ii) mittels Sputtern, beispielsweise ionenstrahlgestützte Deposition, oder (iii) mittels lonenplattieren oder (iv) mittels ICB-Abscheidung (ionized cluster beam deposition, ICBD). Erfindungsgemäß können auch verschiedene physikalischen Gasabscheidungsverfahren, wie beispielsweise Elektronenstrahlverdampfung und Lichtbogenverdampfung kombiniert werden. Eine solche Kombination ist bevorzugt, wenn auf kleinem Raum eine entsprechende Verdampfung der ersten Metalllegierung 3 erreicht werden soll.

Bei den thermischen Verdampfungsverfahren werden die ersten und/oder zweiten Metalllegierungen in geeigneten Vorrichtungen je nach Legierungsart auf bis zu 6.000 °Celsius erhitzt und dabei zu ersten und / oder zweiten Metalllegierungsmolekülen 3, 2 verdampft. Vorzugsweise werden die ersten und/oder zweiten Metalllegierungsmoleküle 3, 2 mit geeigneten Mitteln, vorzugsweise durch Zuleitung eines geeigneten Gases, weiter bevorzugt eines Edelgases alternativ Fluor abgekühlt bevor sie mit dem Polymermaterial in Schritt d), mit der Oberfläche der faserkernverfüllten Polymerfasern 1 in Schritt e) oder der Oberfläche des Vlieses in Schritt f) in Kontakt gebracht werden. Bei der Verdampfung der zweiten Metalllegierungen zu Metalllegierungsmolekülen 2 können zusätzlich sauerstoffhaltige Gase verwendet werden, wie beispielsweise CO₂, da die zweiten Metalllegierungsmoleküle aufgrund der Anordnung an der Oberfläche der Polymerfaser 1 mit Luftsauerstoff in Kontakt kommt. Im Gegensatz hierzu wird bei der Verdampfung der ersten Metalllegierungen zu ersten Metalllegierungsmolekülen 3 eine sauerstofffreie Atmosphäre bevorzugt, damit die ersten Metallegierungsmoleküle 3 nicht oxidiert vorliegen.

Bei der Verdampfung der ersten Metalllegierung entstehen insbesondere erste Metalllegierungsmoleküle 3 mit trigonaler Struktur. Beim Mischen der ersten Metalllegierungsmolekülen 3 mit dem in Schritt b) bereitgestellten Polymermaterial sowie Anordnung des metallisierten Polymermaterials in Faserform, sind die ersten Metalllegierungsmoleküle 3 mit trigonaler Struktur im Wesentlichen im Kern K der Polymerfaser angeordnet und bilden ein Gitter, in dem die einzelnen ersten Metalllegierungsmoleküle 3 jeweils durch das Polymer isoliert vorliegen, aber die Elektronenwolken der benachbarten ersten Metalllegierungsmoleküle 3 überlagern.

Der Anteil an ersten Metalllegierungsmolekülen 3 mit trigonaler Struktur beträgt vorzugsweise 80 Gew.-% bezogen auf das Gesamtgewicht der ersten Metalllegierung im Polymermaterial. Bei der Verdampfung entstehen ebenfalls, allerdings zu einem geringeren Anteil (bis ca. 20 Gew.-% bezogen auf das Gesamtgewicht der ersten Metalllegierung), erste Metalllegierungsmoleküle 3 mit hexa- oder oktagonaler Struktur. Diese ordnen sich allerdings aufgrund ihres höheren Gewichtes an der Oberfläche der Polymerfaser 1 an. Im Rahmen der vorliegenden Erfindung wurde herausgefunden, dass erste Metalllegierungsmoleküle 3 mit hexa- oder oktagonaler Struktur, die an der Oberfläche der Polymerfaser 1 angeordnet sind aufgrund von Reibungen der Polymerfasern 1 untereinander entfernt werden, so dass die Polymerfaser 1 im Wesentlichen, d.h. zu 80 Gew.-% oder mehr, erste Metalllegierungsmolekülen 3 mit trigonaler Struktur umfasst, wobei diese im Wesentlichen im Kern K, also im Innern der Polymerfaser 1 angeordnet sind.

Eine Ausführungsmöglichkeit zur Herstellung entsprechender Polymerfasern 1 wird im Detail im Ausführungsbeispiel beschrieben.

Hierbei wird das Polymermaterial in Tropfenform mit den ersten Metalllegierungsmolekülen 3 zunächst gemischt, bevor es mittels üblicher Verfahren, vorzugsweise mittels E-Spinning zur faserkernverfüllten Polymerfaser 1 angeordnet wird.

Gegebenenfalls kann es notwendig sein vor dem E-Spinning die Viskosität des metallisierten Polymergemisches zu erniedrigen, um ein E-Spinning zu ermöglichen.

Um das Polymermaterial in Tropfenform bereitzustellen, kann jedes üblicherweise geeignete Gerät verwendet werden. Bei Verwendung eines Tintenstrahldruckgeräts, vorzugsweise eines das piezo-elektrisch gesteuert ist, kann die Tropfengröße gezielt gesteuert werden und reproduzierbarere Ergebnisse zu erzielen. Der Tropfen kann mittels üblicher Methoden mit den ersten Metalllegierungsmolekülen gemischt werden. Eine bevorzugte erfindungsgemäße Ausführung besteht darin, dass die erste Metalllegierung aus einem Vorratsbehälter über ein Zuführungssystem vorzugsweise am Druckkopf zu ersten Metalllegierungsmolekülen 3 verdampft wird und beispielsweise mittels eines Druckkopfinjektors in den Polymertropfen eingeleitet wird. Die Menge der ersten Metalllegierung hängt von dem geforderten Frequenzbereich, in dem noch abgeschirmt werden soll ab. Dabei gilt, dass ein höherer Grad an molekularer Faserkernverfüllung mit den ersten Metalllegierungsmolekülen 3 eine Abschirmung in einem höheren Frequenzbereich ermöglicht. Gleichzeitig bedeutet aber eine höhere Faserkernverfüllung eine Reduzierung der Flexibilität des erfindungsgemäßen Vlieses 4.

Üblicherweise wird eine Menge an 10 Gew.% oder mehr erster Metalllegierungsmoleküle 3 bezogen auf das Volumen des Polymermaterials gemischt. Das Volumen des Polymermaterials bedeutet im Rahmen der vorliegenden Erfindung das Volumen des Polymermaterials gegebenenfalls inklusive etwaiger viskositätserniedrigende Mittel.

Eine Menge an 50 Gew.% oder mehr erster Metalllegierungsmoleküle 3 führt zu keiner weiteren Steigerung des Abschirmeffektes, deshalb wird erfindungsgemäß ein Bereich zwischen 10 und 50 Gew.-% erster Metalllegierungsmoleküle 3 bezogen auf das Volumen des Polymermaterials verwendet. Erfindungsgemäß liegt der bevorzugte Bereichen zwischen 15 und 35 Gew.-%, weiter bevorzugt bei 20 bis 30 Gew.-% erster Metalllegierungsmoleküle 3 bezogen auf das Volumen des Polymermaterials.

Der mittlere Partikeldurchmesser (beispielsweise mittels Laserdopplermikrofluss oder Weißlicht-Spektroskopie gemessen) der ersten Metalllegierungsmoleküle 3, insbesondere bei mehr als 80 % der Partikel der ersten Metalllegierungsmoleküle 3 in der faserkernverfüllten Polymerfaser liegt in der Regel bei 2 bis 4 nm, wobei die Atom-Gitter-Struktur der Legierung sich zu einer vorwiegend trigonalen Gitterstruktur ändert. Eine Erklärung hierfür kann sein, dass Oxid-Brücken an der Alpha-Flanke der Metalllegierungsmoleküle abgesprengt werden und sich dabei die trigonalen Bindungsarme etwas ausdehnen.

Die erfindungsgemäßen faserkernverfüllten Polymerfasern 1 haben vorzugsweise einen mittleren Faserdurchmesser DF von ≤ 500 µm, weiter bevorzugt ≤ 100 µm, noch weiter bevorzugt ≤ 50 µm, noch weiter bevorzugt ≤ 1 µm. Der mittlere Faserdurchmesser DF wird beim E-Spinning üblicherweise über den Abstand des Magneten gesteuert.

Erfindungsgemäß kann die Beschichtung der faserkernverfüllten Polymerfasern 1 vor oder nach der Herstellung des erfindungsgemäßen Vlieses 4 durchgeführt werden.

Wenn die Polymerfasern 1 vor Herstellung des erfindungsgemäßen Vlieses 4 mit der zweiten Metalllegierung beschichtet wird, dann werden die Polymerfasern 1 vorzugsweise erst getrocknet und anschließend wird die zweite Metalllegierung aus Schritt c) aus dem Vorratsbehälter mittels einer geeigneten Zuführung mit üblichen Verfahren, wie vorstehend beschrieben, verdampft und auf der Oberfläche H der Polymerfasern 1 angeordnet. Ein solches Verfahren birgt allerdings die Gefahr, dass die zweiten Metalllegierungsmoleküle auf der Oberfläche der Polymerfaser 1 Cluster bilden, welche den Abschirmeffekt schwächen.

Deshalb wird das alternative Verfahren bevorzugt, wonach zuerst mittels üblicher Verfahren durch zufällig unregelmäßiges Anordnen der faserkernverfüllten Polymerfasern 1 in den drei räumlichen Dimensionsrichtungen (X, Y und Z) ein erfindungsgemäßes Vlies 4 hergestellt und dieses vorzugsweise verfestigt und/oder getrocknet wird, bevor die Oberfläche des Vlieses 4 (bzw. die Oberfläche der bereits zu einem Vlies 4 verbundenen Fasern 1) mit der verdampften zweiten Metalllegierung beschichtet wird. Hierbei wird üblicherweise eine Menge an mehr Gew.-% oder mehr, vorzugsweise 10 bis 20 Gew.-% erster Metalllegierungsmoleküle 2 bezogen auf das Volumen des Polymermaterials gegebenenfalls inklusive etwaiger viskositätserniedrigender Mittel verwendet.

Die zweiten Metalllegierungsmoleküle 2 haben in dem Oberflächen-Gitter einen mittleren Partikeldurchmesser (beispielsweise mittels Laserdopplermikrofluss oder Weißlicht-Spektroskopie gemessen) von 5 bis 7 nm. Das Oberflächen-Gitter zeichnet sich erfindungsgemäß dadurch aus, dass die zweiten Metalllegierungsmoleküle 2 isoliert von einander an der Vliesoberfläche H angeordnet sind, und ein Gitter bilden, in dem sich die Elektronenwolken der einzelnen zweiten Metalllegierungsmoleküle 2 überlagern.

Das erfindungsgemäße Vlies 4 hat im nicht verfestigten Zustand üblicherweise eine Schichtdicke DV im Zentimeterbereich, insbesondere 4 bis 8 cm. Im verfestigten Zustand hat das erfindungsgemäße Vlies 4 üblicherweise ein Schichtdicke DV von ≤ 1 mm, vorzugsweise ≤ 500 µm, weiter bevorzugt ≤ 200 µm. Das Gewicht des erfindungsgemäßen Vlieses 4 beträgt vorzugsweise ≤ 500 g/m², weiter bevorzugt ≤ 250 g/m², noch weiter bevorzugt ≤ 100 g/m². Gemäß einer beispielhaften Ausgestaltung kann ein erfindungsgemäßes Vlies bei einer Schichtdicke von ca. 70 µm ein Gewicht von 48 g/m² bzw. bei 200 µm ein Gewicht von 84 g/m² aufweisen.

Gemäß einer kumulativ oder alternativ bevorzugten Ausgestaltung werden zusätzlich ein oder mehrere Materialien bereitgestellt, welche die Temperaturbeständigkeit des erfindungsgemäßen Vlieses 4 verbessern, da bei der Absorption elektromagnetischer Strahlung durch das Oberflächen-Gitter der zweiten Metalllegierung durch Konvektion auch Wärme entsteht. Gemäß dieser bevorzugten Ausgestaltung kann das Material, das die Temperaturbeständigkeit des Polymermaterials verbessert, ausgewählt werden aus glasartigen Materialien, insbesondere Glas, Keramik, und Porzellan, und/oder kohlenstoffhaltigen Materialien, beispielsweise Graphen. Graphen eignet sich aufgrund seines Schmiereffektes insbesondere dann besonders gut, wenn das erfindungsgemäße Vliesmaterial zur Abschirmung von Scharnieren, Öffnungen, und Türen verwendet werden soll.

Die Materialien, welche die Temperaturbeständigkeit des erfindungsgemäßen Vlieses 4 erhöhen, können gemäß üblicher Verfahren mit dem Polymermaterial und der ersten Metalllegierung gemischt werden. Beispielsweise wird das Material, das die Temperaturbeständigkeit des Polymermaterials verbessert, in Pulverform eingebracht und mit dem Metalllegierungsmolekül-Polymergemisch in Schritt d) gemischt, bevor die Polymerfaser 1 hergestellt wird. Vorzugsweise haben die Materialien, welche die Temperaturbeständigkeit des erfindungsgemäßen Vlieses 4 erhöhen einen geeigneten mittleren Partikeldurchmesser, vorzugsweise von ≤ 100 µm, ≤ 50 µm, ≤ 20 µm, ≤ 10 µm oder ≤ 1 µm. Gemäß einer erfindungsgemäßen Ausführungsform wird das Material, dass die Temperaturbeständigkeit des erfindungsgemäßen Vlieses 4 erhöht gemahlen, vorzugsweise nanokristallin gemahlen und zeigt einen mittleren Partikeldurchmesser (beispielsweise mittels Laserdopplermikrofluss oder Weißlicht-Spektroskopie gemessen) von ≤ 500 nm, weiter bevorzugt ≤ 250 nm, insbesondere einen mittleren Partikeldurchmesser im Bereich von 10 nm bis 50 nm.

Mit steigendem Gewichtsanteil an Material, das die Temperaturstabilität der Fasern 1 bzw. des Vlieses 4 erhöht, steigt üblicherweise auch die Temperaturstabilität des erfindungsgemäßen Vliesmaterials 4. Allerdings nimmt die Zugelastizität des erfindungsgemäßen Vliesmaterials 4 mit steigendem Gewichtsanteil ab. Deshalb liegt erfindungsgemäß der Gewichtsanteil von dem Material, das die Temperaturstabilität erhöht, vorzugsweise Glas, Keramik, und Porzellan, und/oder kohlenstoffhaltige Materialien, wie Graphen im Bereich von bis zu 25 Gew.-%, vorzugsweise bei 10 bis 20 Gew.-%, weiter bevorzugt bei 15 Gew.-% bezogen auf das Volumen des Polymermaterials gegebenenfalls inklusive etwaiger viskositätserniedrigende Mittel.

Das erfindungsgemäße Vlies 4, dass gemäß einem der erfindungsgemäßen Herstellverfahren herstellbar ist, zeichnet sich zudem dadurch aus, dass sofern das Polymermaterial aufgrund hoher Hitzeeinwirkung verdampfen würde, die beiden Metallgitter, nämlich das innere Faserkern-Gitter bzw. Faserkern/Temperaturerhöhendes Material - Gitter einerseits und das äußere Oberflächenpolymerfaser-Gitter andererseits weiterhin intakt bleiben. Mit anderen Worten: Es bleiben auch die Funktionen der beiden Gitter, nämlich die Absorption der elektromagentischen Wellen durch das äußere Gitter und die Verarbeitung der durch Konvektion entstandenen statischen Ladung durch das innere Faserkern-Gitter bzw. Faserkern/Temperaturerhöhendes Material - Gitter bestehen und der Abschirmeffekt bleibt intakt. Das Material ist aufgrund des fehlenden Polymers weniger zugstabil. Es ist daher vorstellbar, dass zur besseren Beständigkeit bei Hitzeeinwirkung stabilisierende Maßnahmen eingesetzt werden. Beispielsweise kann das erfindungsgemäße Vlies 4 in einer stabilisierenden Vorrichtung, insbesondere aus Materialien wie Beton, angeordnet sein.

Das erfindungsgemäße Vlies 4 gemäß dem zweiten Erfindungsgegenstand ist vorzugsweise dadurch gekennzeichnet, dass das Vlies 50 bis 60 Gew.-% Polymermaterial, bis zu 50 Gew.-%, vorzugsweise 10 bis 40 Gew-%, weiter bevorzugt 15 bis 35 Gew.-% erste und zweite Metalllegierungen - vorzugsweise 10 bis 15 Gew.-% jeweils der ersten und zweiten Metalllegierung - und gegebenenfalls bis zu 25 Gew.-%, vorzugsweise 10 bis 20 Gew.-% Material zur Verbesserung der Temperaturstabilität jeweils bezogen auf das Gesamtgewicht des erfindungsgemäßen Vlieses 4 aufweist.

Das erfindungsgemäße Vlies 4, das insbesondere zur Abschirmung von Terahertz-Strahlung im Bereich von 5 THz bis 300 THz besonders geeignet ist, hat vorzugsweise
- einen Schrumpfungswert von bis zu 5 % nach DIN 7715 Teil 3 Klasse E3 und/oder
- einen Oberflächenwiderstand von 4 bis 7 Ohm / Zoll, vorzugsweise 5,5 Ohm / Zoll bei 20 mA Prüfstrom in der X-Y-Z Achse des Vlieses 4 und/oder
- eine Temperaturbeständigkeit im Bereich von - 40 °C bis + 120 °C und/oder
- eine Ozonbeständigkeit und/oder
- eine Wasseraufnahmekapazität von ≤ 4 % und/oder
- ein Gewicht von ≤ 250 g/m², vorzugsweise ≤ 100 g / m².

Das erfindungsgemäße Vlies 4 wird erfindungsgemäß zur Abschirmung elektromagnetischer Strahlung, insbesondere von Terahertz-Strahlung, weiter bevorzugt von Terahertz-Strahlung im Bereich von 5 THz bis 300 THz verwendet.

Insbesondere wird das erfindungsgemäße Vlies 4 zur Herstellung von menschlichen oder tierischen Schutzanzügen verwendet, die für die Abschirmung von elektromagnetischer Strahlung, insbesondere von Terahertz-Strahlung, weiter bevorzugt von Terahertz-Strahlung im Bereich von 5 THz bis 300 THz verwendet werden sollen.

Alternativ oder kumulativ wird das erfindungsgemäße Vlies 4 zur Abschirmung von Gebäuden, Fahrzeugen (zu Land, zu Wasser und/oder zu Luft), Gegenständen und/oder Leitungen im Bereich von 5 THz bis 300 THz verwendet.

Alternativ oder kumulativ wird das erfindungsgemäße Vlies 4 zur Herstellung von Polymerisolierungen von Öffnungen in Gebäuden oder Fahrzeugen (zu Land, zu Wasser und/oder zu Luft) oder Leitungen verwendet. Hierbei eignen sich insbesondere solche erfindungsgemäßen Vliesmaterialien bevorzugt, die einen Anteil an kohlenstoffhaltigen Materialien, wie Graphen als temperaturstabilitätserhöhendes Material umfassen. Der Schmiereffekt wird auf Grund des Graphens erhöht, so dass eine verbesserte Abdichtung erreicht wird.

### AUSFÜHRUNGSBEISPEIELE

### Beispiel 1: Herstellung eines erfindungsgemäßen Vlieses

### a) Bereitstellen einer ersten Metalllegierung

5 Gramm FeMnW-(P(_{0,5})Ge(_{0,1})Pb (_{0,4})W (_{0,2})) werden bereitgestellt, wobei die Legierung folgende Gewichtsbestandteile enthält:
1,23 Gramm Eisen (Fe). Alternativ kann auch CuAl anstelle von Fe eingesetzt werden.
0,6 Gramm Mangan (Mn).
0,7 Gramm Wolfram (W).
0,53 Gramm Phosphor (P). Phosphor wird eingesetzt, um eine sauerstofffreie Legierung zu erhalten.
1,25 Gramm Germanium (Ge).
0,7 Gramm Blei (Pb).

Die erste Metalllegierung wird hergestellt in dem das Konstrukt FeMnW auf ca. 1.100 °Celsius erhitzt und dabei verdampft wird. Zudem wird das Konstrukt PGePbW auf 2.000 °Celsius erhitzt.

Das Erhitzen und Verdampfen kann durch übliche Verfahren, wie physikalische Gasphasenabscheidungsverfahren verwendet werden, vorzugsweise (i) mittels Verdampfen, beispielsweise mittels thermischen Verdampfens, Elektronenstrahlverdampfen, Laserstrahlverdampfen, Lichtbogenverdampfen oder Molekularstrahlepitaxie, oder (ii) mittels Sputtern, beispielsweise ionenstrahlgestützte Deposition, oder (iii) mittels lonenplattieren oder (iv) mittels ICB-Abscheidung (ionized cluster beam deposition, ICBD) durchgeführt werden. Vorliegend wurde ein physikalisches Gasphasenabscheidungsverfahren mittels thermischen Verdampfens genutzt. Erfindungsgemäß wird eine Kombination aus Elektronenstrahlverdampfen und Lichtbogenverdampfen eingesetzt um auf kleinem Raum eine kontinuierliche Verdampfung der ersten Metalllegierung zu ermöglichen.

Beide verdampften Konstrukte werden gemischt und vorzugsweise durch Zuführung von sauerstofffreien Gasen, wie Edelgasen oder anderen nicht sauerstoffhaltigen Gasen, wie Fluor auf 650 °Celsius abgekühlt (getempert), so dass die erste Metalllegierung entsteht. Vorliegend wurde Argon verwendet. Der Erfinder hat gefunden, dass bei der Verwendung von fluorhaltigen Gasen Rückstände in den ersten Metalllegierungen verbleiben können, so dass fluorhaltige Gase eher nicht für das erfindungsgemäße Herstellverfahren verwendet werden.

### b) Bereitstellen eines Polymermaterials

Gemäß des vorliegenden Ausführungsbeispiels soll das Vliesmaterial verhältnismäßig fest werden, so dass das Polymer aus der Gruppe der Polyamide, beispielsweise Poly(*p*-phenylenterephthalamid) (PPTA) und Poly(*m*-phenylenisophthalamid) (PMPI) gewählt wird. Als viskositätserniedrigendes Mittel wird Ameisensäure verwendet.

Für den Fall, dass ein weicheres Viesmaterial entstehen soll, wird beispielsweise Polyethylenterephthalat (PET) verwendet, wobei dies vorzugsweise mit hochzyklischen Alkoholen (C5 bis C9), vorzugsweise C6-Alkoholen, bis zu einer geeigneten Viskosität gemischt wird.

Die geeignete Viskosität hängt von dem Verfahren der Mischung der ersten Metalllegierungsmoleküle mit dem Polymermaterial ab.

### c) Bereitstellen einer zweiten Metalllegierung

5 Gramm FeMnP(_{0,5})-(CuSi(_{0,4})) werden bereitgestellt, wobei die Legierung folgende Gewichtsbestandteile enthält:
1,9 Gramm Eisen (Fe).
1,9 Gramm Mangan (Mn).
0,5 Gramm Phosphor (P). Phosphor wird verwendet um vorzugsweise eine sauerstofffreie Metalllegierung zu erhalten.
0,3 Gramm Kuper (Cu).
0,4 Gramm Silicium (Si).

Die zweite Metalllegierung wird hergestellt, in dem das Konstrukt FeMnP auf 1.050 °Celsius und das Konstrukt CuSi auf 1.800 °Celsius erhitzt wird. Beide verdampften Konstrukte werden gemischt und - wie unter a) beschrieben - auf 650 °Celsius abgekühlt (getempert), so dass die zweite Metalllegierung entsteht.

### d) Herstellen von faserkernverfüllten Polymerfasern aus der ersten Metalllegierung und dem Polymermaterial

Vorliegend wird das in Schritt b) bereitgestellte Polymermaterial in Tropfenform, beispielsweise mittels piezo-gesteuerter Tintenstrahltechnik bereitgestellt und mittels eines Druckkopfinjektors wird, bezogen auf das Volumen des Polymertropfens, bis maximal 20 Gew./Vol.%, vorzugsweise 10 bis 15 Gew./Vol.% der ersten Metalllegierungsmoleküle eingeleitet. Mit anderen Worten: 100 ml metallisiertes Polymermaterial hat einen Anteil von bis zu 5 Gramm, vorzugsweise 2,5 Gramm bis 3,75 Gramm erster Metalllegierungsmoleküle.

Die Viskosität des Polymermaterials wird gegebenenfalls so eingestellt, dass das Polymermaterial in Tropfenform bereitgestellt werden kann und in diesen Tropfen die ersten Metalllegierungsmoleküle eingebracht werden können.

Der Metalldampf der ersten Metalllegierung wird vorliegend durch Laserverdampfung am Druckkopf erzeugt. Alternativ können andere Techniken verwendet werden, beispielsweise Elektrodenverdampfung.

Der metallisierte Polymertropfen wird anschließend mittels geeigneter Techniken, vorliegend eine Kombination aus E-Spinning und Zufuhr verhältnismäßig kalten, sauerstofffreien Gases, wie vorliegend Argon, zu einer faserkernverfüllten Polymerfaser gezogen und abgekühlt. Hierbei steuert der Abstand des elektromagnetischen Feldes die Dicke der faserkernverfüllten Polymerfaser. Dabei wird der Durchmesser der faserkernverfüllten Polymerfaser 1 umso dicker, je größer der Abstand zum Magneten ist.

Der mittlere Partikeldurchmesser der ersten Metalllegierungsmoleküle in der faserkernverfüllten Polymerfaser 1 liegt in der Regel bei 2 bis 4 nm (vorzugsweise bei > 80 % der Partikel), wobei die Atom-Gitter-Struktur der Legierung sich zu einer vorwiegend trigonalen Gitterstruktur ändert. Eine Erklärung hierfür kann sein, dass Oxid-Brücken an der Alpha-Flanke der Metalllegierungsmoleküle abgesprengt werden und dabei sich die trigonalen Bindungsarme etwas ausdehnen.

Die erfindungsgemäßen faserkernverfüllten Polymerfasern haben vorzugsweise einen mittleren Durchmesser von ≤ 500 µm, weiter bevorzugt ≤ 100 µm, noch weiter bevorzugt ≤ 50 µm, noch weiter bevorzugt ≤ 1 µm.

Durch das zufällig unregelmäßige Ablegen und Anordnen der faserkernverfüllten Polymerfasern nach Elektrospinning und kalter Gaszufuhr wird ein Vlies hergestellt, wobei dieses Vlies eine Dicke im Zentimeterbereich hat, ungefähr im Bereich von 4 bis 8 cm. Das so erhaltene Vlies hat einen Feuchtigkeitsanteil von ca. 40 % bezogen auf das Gewicht des Vlies.

Vorliegend wird das Vlies bevorzugt verfestigt und getrocknet bevor mittels physikalischer Gasphasenabscheidung mittels plasmatischer Verdampfung die zweite Metalllegierung als Gitter auf zumindest einen Teil der Oberfläche des Vlieses beschichtet wird. Die Schichtdicke des so verfestigten Vlieses liegt bei 200 µm und einem Gewicht von 84 g/m² und kann auch eine Schichtdicke von ca. 70 µm und einem Gewicht von 48 g/m² einnehmen.

Die zweiten Metalllegierungsmoleküle haben in dem Oberflächen-Gitter einen mittleren Partikeldurchmesser von 5 bis 7 nm. Das Oberflächen-Gitter zeichnet sich dadurch aus, dass die zweiten Metalllegierungsmoleküle isoliert von einander an der Vliesoberfläche angeordnet sind, und ein Gitter bilden, in dem sich die Elektronenwolken der einzelnen zweiten Metalllegierungsmoleküle überlagern.

Aus 100 ml Polymermaterial gegebenenfalls inklusive etwaiger viskositätserniedrigender Mittel und bis zu 5 Gramm erster Metalllegierung kann ein erfindungsgemäßes Vlies mit einer Fläche von 10 dm² gesponnen werden (entsprechend werden bis zu 50 Gramm erster Metalllegierung für 1 qm² erfindungsgemäßes Vlies benötigt).

Das erfindungsgemäß hergestellte Vlies 4 ermöglicht die Abschirmung von elektromagnetischer Strahlung, insbesondere von Terahertz-Strahlung im Bereich von 5 THz bis 300 THz , aber auch höher- und niederfrequenterer Strahlung, wobei die Ladungen durch auf der Oberfläche der Polymerfaser 1 befindliche zweite Metalllegierungs-Gitter in die Tiefe des erfindungsgemäßen Vlieses 4 gezogen werden, weil die ersten Metalllegierungsmoleküle 3 im Kern einen Ladungsunterschied zur Oberfläche aufweisen. Zudem sind die ersten Metalllegierungsmoleküle 3 im Kern K schneller in der Stromweiterleitung bzw. in der Ladungskompensation als die zweiten Metalllegierungsmoleküle 2 des Oberflächen-Gitters. Hierdurch entsteht eine lokale "Unterladung" im Mikrometermaßstab. Aufgrund der zufälligen, unregelmäßigen Anordnung der faserkernverfüllten Polymerfasern im erfindungsgemäßen Vlies heben sich die Ladungen bzw. Potentialunterschiede bezogen auf das erfindungsgemäße Vlies als Ganzes annähernd auf.

### Beispiel 2: Physikalische Kennziffern des erfindungsgemäßen Vlieses aus Beispiel 1

Das erfindungsgemäße Vlies zeigt folgende Schirmdämpfungswerte:
Bei 30 THz: 80 bis 90 %
Bei 300 THz: 15 bis 20 %

Das erfindungsgemäße Vlies zeigt folgenden Widerstand in X-Y-Z Achse des erfindungsgemäßen Vlieses:
5,5 Ohm / Zoll bei 20 mA Prüfstrom

Das erfindungsgemäße Vlies zeigt folgende Beständigkeiten:

| Wetter | Sehr gut |
|---|---|
| Öl und Benzin | gut |
| Alterung | Sehr beständig |
| Lösungsmittel | Mittel |
| Laugen | Gut |
| Ozon | Gut |

Das erfindungsgemäße Vlies zeigt folgende Brennbarkeiten gemäß DIN 4102 B1:
Brennbar nach 25 Minuten bei 270 °Celsius und nach 40 Minuten bei 240 °Celsius.
Brandfest nach UL 94-HB und UL 94-VO.

Das erfindungsgemäße Vlies zeigt eine hohe Permeabilität und ist entsprechend Atmungsaktiv.

Das erfindungsgemäße Vlies zeigt eine Schrumpfung und Toleranzen bis 5 % beispielsweise gemessen nach DIN 7715 Teil 3 Klasse E3.

Das erfindungsgemäße Vlies ist Temperaturbeständig im Bereich von - 40 °Celsius bis + 120 °Celsius.

Das erfindungsgemäße Vlies ist Ozonbeständig und zeigt keine Risse.

Das erfindungsgemäße Vlies zeigt eine Wasseraufnahme von < 4 % bezogen auf das Gewicht des Vlieses.

## Patentansprüche

1. Verfahren zur Herstellung eines Vlieses (4) zur Abschirmung von elektromagnetischer Strahlung, insbesondere im Terahertz (THz)- Bereich, insbesondere im Bereich von 5 THz bis 300 THz, umfassend oder bestehend aus einem in drei Dimensionsrichtungen (X, Y und Z) des Vlieses (4) zufällig unregelmäßig angeordneten Netzwerk von beschichten, faserkernverfüllten Polymerfasern (1), **dadurch gekennzeichnet, dass** das Verfahren folgende Schritte umfasst oder daraus besteht:
a. Bereitstellen einer ersten Metalllegierung (3), die geeignet ist elektromagentische Strahlung abzuschirmen, insbesondere im Terahertz (THz) Bereich, insbesondere im Bereich von 5 THz bis 300 THz,
b. Bereitstellen eines Polymermaterials,
c. Bereitstellen einer zweiten Metalllegierung (2), die sich von der ersten Metalllegierung aus Schritt a) dadurch unterscheidet, dass ein Ladungspotentialunterschied zwischen der ersten und zweiten Metalllegierung hervorgerufen werden kann,
d. Herstellen von faserkernverfüllten Polymerfasern (1) durch Verdampfen der ersten Metalllegierung (3) aus Schritt a) zu ersten Metalllegierungsmolekülen mit trigonaler Struktur und Mischen der ersten Metalllegierungsmoleküle mit dem in Schritt b) bereitgestellten Polymermaterial sowie Anordnung des metallisierten Polymermaterials in Faserfom, wobei die ersten Metalllegierungsmoleküle mit trigonaler Struktur im Wesentlichen im Kern der Polymerfaser angeordnet sind und ein Gitter bilden, in dem die einzelnen ersten Metalllegierungsmoleküle jeweils durch das Polymer isoliert vorliegen, aber die Elektronenwolken der benachbarten ersten Metalllegierungsmoleküle überlagern, und
e. Beschichten zumindest eines Teils der Oberfläche der faserkernverfüllten Polymerfasern (1) aus Schritt d) mit der zweiten Metalllegierung (2) aus Schritt c), wobei die zweite Metalllegierung (2) zu einzelnen zweiten Metalllegierungsmolekülen mit hexa- oder oktagonale Struktur verdampft wird und diese isoliert von einander an der Polymerfaseroberfläche angeordnet sind und ein Oberflächen-Gitter bilden, in dem sich die Elektronenwolken der einzelnen zweiten Metalllegierungsmoleküle überlagern, und Herstellen des Vlieses (4) durch zufällig unregelmäßiges Anordnen der beschichteten, faserkernverfüllten Polymerfasern (1) in den drei räumlichen Dimensionsrichtungen (X, Y und Z) oder
f. Herstellen des Vlieses (4) durch zufällig unregelmäßiges Anordnen der faserkernverfüllten Polymerfasern (1) aus Schritt d) in den drei räumlichen Dimensionsrichtungen (X, Y und Z) und Beschichten zumindest eines Teils der Oberfläche des Vlieses (4) mit der zweiten Metalllegierung (2) aus Schritt c), wobei die zweite Metalllegierung (2) zu einzelnen zweiten Metalllegierungsmolekülen mit hexa- oder oktagonale Struktur verdampft wird und diese isoliert von einander an der Polymerfaseroberfläche angeordnet sind und ein Oberflächen-Gitter bilden, in dem sich die Elektronenwolken der einzelnen zweiten Metalllegierungsmoleküle überlagern.

2. Verfahren zur Herstellung des Vlieses (4) gemäß Anspruch 1, **dadurch gekennzeichnet, dass** für die Herstellung der ersten Metalllegierungsmoleküle in Schritt d) und/oder der zweiten Metalllegierungsmoleküle in Schritt e) physikalische Gasphasenabscheidungsverfahren verwendet werden, vorzugsweise (i) mittels Verdampfen, beispielsweise mittels thermischen Verdampfens, Elektronenstrahlverdampfen, Laserstrahlverdampfen, Lichtbogenverdampfen oder Molekularstrahlepitaxie, oder (ii) mittels Sputtern, beispielsweise ionenstrahlgestützte Deposition, oder (iii) mittels lonenplattieren oder (iv) mittels ICB-Abscheidung (ionized cluster beam deposition, ICBD).

3. Verfahren zur Herstellung des Vlieses (4) gemäß Anspruch 1 oder 2, **dadurch gekennzeichnet, dass** die ersten Metalllegierungsmoleküle in Schritt a) und/oder die zweiten Metalllegierungsmoleküle in Schritt c) mit geeigneten Mitteln, vorzugsweise durch Zuleitung eines geeigneten Gases, weiter bevorzugt eines Edelgases abgekühlt werden bevor sie mit dem Polymermaterial in Schritt d), mit der Oberfläche der faserkernverfüllten Polymerfasern in Schritt e) oder der Oberfläche des Vlieses (4) in Schritt f) in Kontakt gebracht werden.

4. Verfahren zur Herstellung des Vlieses (4) gemäß einem der vorstehenden Ansprüche, **dadurch gekennzeichnet, dass** die ersten und zweiten Metalllegierungen (3, 2) in Schritt a) und Schritt c) in Pulverform, vorzugsweise mit einem mittleren Partikeldurchmesser im Bereich von ≤ 100 µm, weiter bevorzugt ≤ 50 µm, noch weiter bevorzugt ≤ 20 µm vorliegen.

5. Verfahren zur Herstellung des Vlieses (4) gemäß einem der vorstehenden Ansprüche, **dadurch gekennzeichnet, dass** das Polymermaterial in Schritt b) in einer Vorrichtung bereit gestellt wird, die das Polymermaterial in Schritt d) in Tropfenform für die Einbringung der ersten Metalllegierungsmoleküle in das Polymermaterial bereitstellt, wobei die Vorrichtung vorzugsweise piezoelektrisch gesteuert ist.

6. Verfahren zur Herstellung des Vlieses (4) gemäß einem der vorstehenden Ansprüche, **dadurch gekennzeichnet, dass** die faserkernverfüllten Polymerfasern (1) in Schritt d) mittels Elektrospinnen hergestellt werden, wobei die faserkernverfüllten Polymerfasern (1) vorzugsweise einen mittleren Partikeldurchmesser von ≤ 500 µm, weiter bevorzugt ≤ 100 µm, noch weiter bevorzugt ≤ 50 µm, noch weiter bevorzugt ≤ 1 µm haben.

7. Verfahren zur Herstellung des Vlieses (4) gemäß einem der vorstehenden Ansprüche, **dadurch gekennzeichnet, dass** die erste Metalllegierung (3) aus Schritt a) und/oder die zweite Metalllegierung (2) aus Schritt c) ein, zwei, drei oder mehrere unterschiedliche Metalllegierungen umfasst,
insbesondere wobei die Metalle der ersten Metalllegierung(en) (3) aus Schritt a) aus zwei, drei, vier oder mehreren Metallen ausgewählt werden aus der Gruppe bestehend aus Blei (Pb), Titan (Ti), Paladium (Pd), Praeseodym (Pr), Lanthan (La), Indium (In), Kobalt (Co), Aluminium (AI), Chrom (Cr), Nickel (Ni), Molybdän (Mo), Barium (Ba), Yttrium (Y), Samarium (Sm), Silizium (Si), Germanium (Ge) und Eisen (Fe),
insbesondere wobei die Metalle der zweiten Metalllegierung(en) (2) aus Schritt c) aus zwei, drei, vier oder mehreren Metallen ausgewählt werden aus der Gruppe bestehend aus Eisen (Fe), Mangan (Mn), Kupfer (Cu), Zink (Zn), Wolfram (W), Silicium (Si), Silber (Ag) und Zinn (Sn).

8. Verfahren zur Herstellung des Vlieses (4) gemäß einem der vorstehenden Ansprüche, **dadurch gekennzeichnet, dass** die ersten Metalllegierungen (3) aus Schritt a) ausgewählt werden aus der Gruppe bestehend aus Kobalt-Legierungen, beispielsweise Co_{68.7}Fe₄Ni₁B₁₃Si₁₁Mo_{2.3}, Nd₃Fe₆₈₋ₓMnₓCo₁₈B₁₁ (x = 0, 1, 2) oder CoFe₂; Paladium-Legierungen, vorzugsweise Paladium-Indium-Eisen Legierungen, beispielsweise Pd₅₇In₂₅Fe₁₈, und Pd_{56.2}In_{26.3}Fe_{17.5}; vorzugsweise Titan-Paladium-Eisen Legierungen, beispielsweise Ti₅₀Pd₄₀Fe₁₀, und Ti₅₀Pd₃₅Fe₁₅; vorzugsweise Paladium-Mangan-Indium Legierungen, beispielsweise Pd₂MnIn; Indium-Phosphat Legierungen, beispielsweise InPO₃; Manganat-Legierungen, beispielsweise Praseodym-Lanthan-Calcium-Manganat Legierungen wie Praseodym-Calcium-Manganat Legierungen oder Lanthan-Calcium-Manganat Legierungen, wie beispielsweise Pr_{0.7}Ca_{0.3}MnO₃ oder La_{0.7}Ca_{0.3}MnO₃; Neodym-Blei-Manganat Legierungen wie Nd_{0.5}Pb_{0.5}MnC₃, Lanthan-Barium-Manganat Legierungen wie La_{2/3}Ba_{1/3}MnO₃; Bor-Kupfer Legierungen wie B₂CuO₂; Legierungen mit hohem Wolframanteil wie Barium-Yttrium-Kupfer-Wolfram Legierungen und Kupfer-Samarium-Wolfram Legierungen und Eisenlegierungen, wie FeNiMo, Fe₈₅Si_{3.5}Al_{5.5}Cr₆ und FeMnW-(P_{0,5}Ge_{0,1}Pb _{0,4}W_{0,2}), und/oder
wobei die zweiten Metalllegierungen (2) aus Schritt c) ausgewählt werden aus der Gruppe bestehend aus Mangan Legierungen, vorzugsweise Nickel-Mangan-Zinn Legierungen, beispielsweise Ni₂Mn_{1.44}Sn_{0.56}, und Ni₂Mn_{1.42}Sn_{0.58}; vorzugsweise Nickel-Mangan-Gallium Legierungen, beispielsweise Ni₂MnGa; vorzugsweise Eisen-Mangan-Silicium Legierungen, beispielsweise FeMnSi, Fe_{57.4}Mn₃₅Si_{7.6}, Fe_{66.7}Mn_{28.8}Si_{6.5} und FeMnW-(P_{0,5}Ge_{0,1}Pb_{0,4}W_{0,2}); und Silber-Magnesium Legierungen, beispielsweise Ag-MgF₂-Ag, und/oder
wobei die ersten und zweiten Metalllegierungen (3, 2) aus Schritt a) und Schritt c) sauerstofffrei sind.

9. Verfahren zur Herstellung des Vlieses (4) gemäß einem der vorstehenden Ansprüche, **dadurch gekennzeichnet, dass** zusätzlich ein oder mehrere Materialien bereitgestellt werden, welche die Temperaturbeständigkeit des Vlieses (4) verbessern, und in Schritt d) in das Metalllegierungsmolekül-Polymergemisch eingearbeitet werden,
insbesondere wobei das Material, das die Temperaturbeständigkeit des Polymermaterials verbessert, ausgewählt wird aus glasartigen Materialien, insbesondere Glas, Keramik, und Porzellan, und/oder kohlenstoffhaltigen Materialien, insbesondere Graphen,
insbesondere wobei das Material, das die Temperaturbeständigkeit des Polymermaterials verbessert, als Pulver in das Metalllegierungsmolekül-Polymergemisch in Schritt d) eingebracht wird.

10. Verfahren zur Herstellung des Vlieses (4) gemäß einem der vorstehenden Ansprüche, **dadurch gekennzeichnet, dass** das Polymermaterial aus Schritt b) ausgewählt wird aus der Liste bestehend aus der Gruppe der Polyester, beispielsweise Polyethylenterephthalat (PET), und der Gruppe der Polyamide, beispielsweise Poly(*p*-phenylenterephthalamid) (PPTA) und Poly(*m*-phenylenisophthalamid) (PMPI).

11. Verfahren zur Herstellung des Vlieses (4) gemäß einem der vorstehenden Ansprüche, **dadurch gekennzeichnet, dass** das hergestellte Vlies (4) eine Schichtdicke von ≤ 1 mm hat, vorzugsweise ≤ 500 µm, weiter bevorzugt ≤ 200 µm.

12. Vlies (4) zur Abschirmung elektromagnetischer Strahlung, herstellbar gemäß einem der Ansprüche 1 bis 11.

13. Vlies (4) gemäß Anspruch 12, **dadurch gekennzeichnet, dass** das Vlies (4) für Terahertz-Strahlung im Bereich von 5 THz bis 300 THz eine Schirmdämpfung von ≥ 10 % hat, vorzugsweise bei 30 THz eine Schirmdämpfung von ≥ 70 %, weiter bevorzugt ≥ 80 %, noch weiter bevorzugt ≥ 90 % hat und/oder vorzugsweise bei 300 THz eine Schirmdämpfung von ≥ 15 %, bevorzugt ≥ 20 % hat, und/oder
wobei das Vlies für Terahertz-Strahlung im Bereich 5 THz bis 300 THz einen Dämpfungswert von ≥ 100 Dezibel (dB) aufweist, und/oder wobei das Vlies (4) 50 bis 60 Gew.-% Polymermaterial, bis zu 50 Gew.-%, vorzugsweise 10 bis 40 Gew-%, weiter bevorzugt 15 bis 35 Gew.-% erste und zweite Metalllegierungen und gegebenenfalls bis zu 25 Gew.-%, vorzugsweise 10 bis 20 Gew.-% Material zur Verbesserung der Temperaturstabilität jeweils bezogen auf das Gesamtgewicht des Vlieses (4) aufweist, und/oder
wobei das Vlies (4) einen Schrumpfungswert von bis zu 5 % nach DIN 7715 Teil 3 Klasse E3 aufweist und/oder einen Oberflächenwiederstand von 4 bis 7 Ohm / Zoll, vorzugsweise 5,5 Ohm / Zoll bei 20 mA Prüfstrom in der X-Y-Z Achse des Vlieses (4) aufweist und/oder temperaturbeständig im Bereich von - 40 °C bis + 120 °C ist und/oder ozonbeständig ist und/oder eine Wasseraufnahmekapazität von ≤ 4 % aufweist und/oder ein Gewicht von ≤ 200 g / m², vorzugsweise ≤ 100 g / m² hat.

14. Verwendung des Vlieses (4) gemäß einem der Ansprüche 12 oder 13 zur Abschirmung von Terahertz-Strahlung im Bereich von 5 THz bis 300 THz, und/oder
zur Herstellung von menschlichen oder tierischen Schutzanzügen, und/oder
zur Abschirmung von Gebäuden, Fahrzeugen (zu Land, zu Wasser und/oder zu Luft), Gegenständen und/oder Leitungen, und/oder
zur Herstellung von Polymerisolierungen von Öffnungen in Gebäuden oder Fahrzeugen (zu Land, zu Wasser und/oder zu Luft) oder Gegenständen oder Leitungen.

## Claims

1. A method for producing a nonwoven (4) for shielding electromagnetic radiation, in particular in the terahertz (THz) range, more particularly in the range from 5 THz to 300 THz, comprising or consisting of a network of coated polymer fibers (1) with filled fiber cores that is arranged randomly and irregularly in three dimensional directions (X, Y and Z) of the nonwoven (4), **characterized in that** the method comprises or consists of the following steps:
a. providing a first metal alloy (3) adapted to shield electromagnetic radiation, in particular in the terahertz (THz) range, more particularly in the range from 5 THz to 300 THz,
b. providing a polymer material,
c. providing a second metal alloy (2) which differs from the first metal alloy of step a) **in that** a charge potential difference can be effected between the first and second metal alloys,
d. producing polymer fibers (1) with filled fiber cores by evaporating the first metal alloy (3) of step a) into first metal alloy molecules having a trigonal structure and mixing the first metal alloy molecules with the polymer material provided in step b) as well as arranging the metalized polymer material in fiber form, wherein the first metal alloy molecules having a trigonal structure are essentially arranged inside the core of the polymer fiber and form a lattice in which the individual first metal alloy molecules are each isolated by the polymer but overlie the electron clouds of the adjacent first metal alloy molecules, and
e. coating at least a part of the surface of the polymer fibers (1) with filled fiber cores of step d) with the second metal alloy (2) of step c), wherein the second metal alloy (2) is evaporated into individual second metal alloy molecules having a hexagonal or octagonal structure which are arranged on the polymer fiber surface isolated from one another and form a surface lattice in which the electron clouds of the individual second metal alloy molecules overlie one another, and producing the nonwoven (4) by randomly and irregularly arranging the coated polymer fibers (1) with filled fiber cores in the three spatial dimensional directions (X, Y and Z), or
f. producing the nonwoven (4) by randomly and irregularly arranging the polymer fibers (1) with filled fiber cores of step d) in the three spatial dimensional directions (X, Y and Z) and coating at least a part of the surface of the nonwoven (4) with the second metal alloy (2) of step c), wherein the second metal alloy (2) is evaporated into individual second metal alloy molecules having a hexagonal or octagonal structure which are arranged on the polymer fiber surface isolated from one another and form a surface lattice in which the electron clouds of the individual second metal alloy molecules overlie one another.

2. The method for producing the nonwoven (4) according to claim 1, **characterized in that** physical vapor deposition processes are used for the production of the first metal alloy molecules in step d) and/or the second metal alloy molecules in step e), preferably (i) using evaporation, for example using thermal evaporation, electron beam evaporation, laser beam evaporation, arc evaporation or molecular beam epitaxy, or (ii) using sputtering, for example ion beam deposition, or (iii) using ion plating, or (iv) using ionized cluster beam deposition (ICBD).

3. The method for producing the nonwoven (4) according to claim 1 or 2, **characterized in that** the first metal alloy molecules in step a) and/or the second metal alloy molecules in step c) are cooled with suitable means, preferably by feeding a suitable gas, more preferably a noble gas, before they are brought into contact with the polymer material in step d), the surface of the polymer fibers with filled fiber cores in step e), or the surface of the nonwoven (4) in step f).

4. The method for producing the nonwoven (4) according to any of the preceding claims, **characterized in that** the first and second metal alloys (3, 2) in step a) and step c) are provided in powder form, preferably with a mean particle diameter in the range of ≤ 100 µm, more preferably ≤ 50 µm, even more preferably ≤ 20 µm.

5. The method for producing the nonwoven (4) according to any of the preceding claims, **characterized in that** in step b) the polymer material is provided in an apparatus which in step d) provides the polymer material in drop form for introduction of the first metal alloy molecules into the polymer material, the apparatus preferably being controlled piezoelectrically.

6. The method for producing the nonwoven (4) according to any of the preceding claims, **characterized in that** in step d) the polymer fibers (1) with filled fiber cores are produced using electrospinning, wherein the polymer fibers (1) with filled fiber cores preferably have a mean particle diameter of ≤ 500 µm, more preferably ≤ 100 µm, even more preferably ≤ 50 µm, even more preferably ≤ 1 µm.

7. The method for producing the nonwoven (4) according to any of the preceding claims, **characterized in that** the first metal alloy (3) of step a) and/or the second metal alloy (2) of step c) comprises one, two, three or more different metal alloys,
in particular wherein the metals of the first metal alloy(s) (3) of step a) are selected from two, three, four or more metals from the group consisting of lead (Pb), titanium (Ti), palladium (Pd), praseodymium (Pr), lanthanum (La), indium (In), cobalt (Co), aluminum (Al), chromium (Cr), nickel (Ni), molybdenum (Mo), barium (Ba), yttrium (Y), samarium (Sm), silicon (Si), germanium (Ge) and iron (Fe),
in particular wherein the metals of the second metal alloy(s) (2) of step c) are selected from two, three, four or more metals from the group consisting of iron (Fe), manganese (Mn), copper (Cu), zinc (Zn), tungsten (W), silicon (Si), silver (Ag) and tin (Sn).

8. The method for producing the nonwoven (4) according to any of the preceding claims, **characterized in that** the first metal alloys (3) of step a) are selected from the group consisting of cobalt alloys, for example Co_{68.7}Fe₄Ni₁B₁₃Si₁₁Mo_{2.3}, Nd₃Fe₆₈₋ₓMnₓCo₁₈B₁₁ (x = 0, 1, 2) or CoFe₂; palladium alloys, preferably paladium-indium-iron alloys, for example Pd₅₇In₂₅Fe₁₈, and Pd_{56.2}In_{26.3}Fe_{17.5}; preferably titanium-palladium-iron alloys, for example Ti₅₀Pd₄₀Fe₁₀, and Ti₅₀Pd₃₅Fe₁₅; preferably palladium-manganese-indium alloys, for example Pd₂MnIn; indium-phosphate alloys, for example InPO₃; manganate alloys, for example praseodymium-lanthanum-calcium-manganate alloys such as praseodymium-calcium-manganate alloys or lanthanum-calcium-manganate alloys, for example Pr_{0.7}Ca_{0.3}MnO₃ or La_{0.7}Ca_{0.3}MnO₃; neodymium-lead-manganate alloys such as Nd_{0.5}Pb_{0.5}MnO₃, lanthanum-barium-manganate alloys such as La_{2/3}Ba_{1/3}MnO₃; boron-copper alloys such as B₂CuO₂; alloys with a high tungsten content such as barium-yttrium-copper-tungsten alloys and copper-samarium-tungsten alloys and iron alloys such as FeNiMo, Fe₈₅Si_{3.5}Al_{5.5}Cr₆ and FeMnW-(P_{0,5}Ge_{0,1}Pb_{0,4}W_{0,2}), and/or
wherein the second metal alloys (2) of step c) are selected from the group consisting of manganese alloys, preferably nickel-manganese-tin alloys, for example Ni₂Mn_{1.44}Sn_{0.56}, and Ni₂Mn_{1.42}Sn_{0.58}; preferably nickel-manganese-gallium alloys, for example Ni₂MnGa; preferably iron-manganese-silicon alloys, for example FeMnSi, Fe_{57.4}Mn₃₅Si_{7.6}, Fe_{66.7}Mn_{28.8}Si_{6.5} and FeMnW-(P_{0,5}Ge_{0,1}Pb_{0,4}W_{0,2}); and silver-magnesium alloys, for example Ag-MgF₂-Ag, and/or
wherein the first and second metal alloys (3, 2) of step a) and step c) are oxygen-free.

9. The method for producing the nonwoven (4) according to any of the preceding claims, **characterized in that** one or more materials which improve the temperature stability of the nonwoven (4) are additionally provided and are incorporated in the metal alloy molecule-polymer mixture in step d),
in particular wherein the material which improves the temperature stability of the polymer material is selected from glass-like materials, in particular glass, ceramics and porcelain, and/or carbonaceous materials, in particular graphene,
in particular wherein the material which improves the temperature stability of the polymer material is added to the metal alloy molecule-polymer mixture as a powder in step d).

10. The method for producing the nonwoven (4) according to any of the preceding claims, **characterized in that** the polymer material of step b) is selected from the list consisting of the group of polyesters, for example polyethylene terephthalate (PET), and the group of polyamides, for example poly(p-phenylene therephthalamide) (PPTA) and poly(m-phenylene isophthalamide) (PMPI).

11. The method for producing the nonwoven (4) according to any of the preceding claims, **characterized in that** the produced nonwoven (4) has a layer thickness of ≤ 1 mm, preferably ≤ 500 µm, more preferably ≤ 200 µm.

12. A nonwoven (4) for shielding electromagnetic radiation, which obtainable according to any of claims 1 to 11.

13. The nonwoven (4) according to claim 12, **characterized in that**, for terahertz radiation in the range from 5 THz to 300 THz, the nonwoven (4) has a shielding effectiveness of ≥ 10 %, preferably a shielding effectiveness of ≥ 70 % at 30 THz, more preferably ≥ 80 %, even more preferably ≥ 90 %, and/or preferably has a shielding effectiveness of ≥ 15 %, preferably ≥ 20 %, at 300 THz, and/or
wherein the nonwoven has an attenuation value of ≥ 100 decibels (dB) for terahertz radiation in the range from 5 THz to 300 THz, and/or
wherein the nonwoven (4) includes 50 to 60 wt% of polymer material, up to 50 wt%, preferably 10 to 40 wt%, more preferably 15 to 35 wt% of first and second metal alloys and, where appropriate, up to 25 wt%, preferably 10 to 20 wt%, of material for improving the temperature stability, respectively based on the total weight of the nonwoven (4), and/or wherein the nonwoven (4) has a shrinkage value of up to 5 % according to DIN 7715, part 3, class E3, and/or has a surface resistance of 4 to 7 ohms/inch, preferably 5.5 ohms/inch, at a 20 mA test current in the X-Y-Z axis of the nonwoven (4), and/or is temperature stable in the range from -40 °C to +120 °C, and/or is ozone-resistant, and/or has a water absorption capacity of ≤ 4 %, and/or has a weight of ≤ 200 g/m², preferably ≤ 100 g/m².

14. Use of the nonwoven (4) according to any of claims 12 or 13 for shielding terahertz radiation in the range from 5 THz to 300 THz, and/or
for producing protective suits for humans or animals, and/or
for shielding buildings, (land, waterborne and/or airborne) vehicles, objects, and/or pathways, and/or
for producing polymer insulations of openings in buildings or (land, waterborne and/or airborne) vehicles or objects or pathways.

## Revendications

1. Procédé de fabrication d'un non-tissé (4) pour le blindage contre un rayonnement électromagnétique, en particulier dans le domaine des térahertz (THz), notamment dans le domaine de 5 THz à 300 THz, comprenant ou composé d'un réseau de fibres polymères (1) enduites et à noyaux de fibre remplis, disposées de manière aléatoire et irrégulière dans trois directions dimensionnelles (X, Y et Z) du non-tissé (4), **caractérisé en ce que** le procédé comprend ou consiste en les étapes suivantes :
a. fournir un premier alliage métallique (3) adapté au blindage contre un rayonnement électromagnétique, en particulier dans le domaine des térahertz (THz), notamment dans le domaine de 5 THz à 300 THz,
b. fournir un matériau polymère,
c. fournir un deuxième alliage métallique (2) qui est différent du premier alliage métallique de l'étape a) **en ce qu'**une différence de potentiel de charge peut être provoquée entre le premier et le deuxième alliage métallique,
d. produire des fibres polymères (1) à noyaux de fibre remplis par évaporation du premier alliage métallique (3) de l'étape a) de manière à former des premières molécules d'alliage métallique à structure trigonale, et mélange des premières molécules d'alliage métallique avec le matériau polymère fourni à l'étape b), et disposition du matériau polymère métallisé en forme de fibre, les premières molécules d'alliage métallique à structure trigonale étant disposées sensiblement dans le noyau de la fibre polymère et formant un réseau dans lequel les premières molécules d'alliage métallique individuelles sont chacune présentes isolées par le polymère, mais superposent les nuages d'électrons des premières molécules d'alliage métallique adjacentes, et
e. revêtir au moins une partie de la surface des fibres polymères (1) à noyaux de fibre remplis de l'étape d) du deuxième alliage métallique (2) de l'étape c), le deuxième alliage métallique (2) étant évaporé de manière à former des deuxièmes molécules d'alliage métallique individuelles à structure hexagonale ou octogonale et celles-ci étant disposées de manière isolées les unes des autres à la surface des fibres polymères et formant un réseau de surface dans lequel les nuages d'électrons des deuxièmes molécules d'alliage métallique individuelles se superposent, et fabrication du non-tissé (4) en disposant les fibres polymères (1) enduites et à noyaux de fibre remplis de manière aléatoire et irrégulière dans trois directions dimensionnelles spatiales (X, Y et Z), ou
f. fabriquer le non-tissé (4) en disposant les fibres polymères (1) à noyaux de fibre remplis de l'étape d) de manière aléatoire et irrégulière dans les trois directions dimensionnelles spatiales (X, Y et Z) et en revêtant au moins une partie de la surface du non-tissé (4) du deuxième alliage métallique (2) de l'étape c), le deuxième alliage métallique (2) étant évaporé de manière à former des deuxièmes molécules d'alliage métallique individuelles à structure hexa- ou octagonale et celles-ci étant disposées de manière isolées les unes des autres à la surface des fibres polymères et formant un réseau de surface dans lequel les nuages d'électrons des deuxièmes molécules d'alliage métallique individuelles se superposent.

2. Procédé de fabrication du non-tissé (4) selon la revendication 1, **caractérisé en ce que** des procédés physiques de dépôt en phase vapeur sont utilisés pour la fabrication des premières molécules d'alliage métallique à l'étape d) et/ou des deuxièmes molécules d'alliage métallique à l'étape e), de préférence (i) par évaporation, par exemple par évaporation thermique, par évaporation par faisceau électronique, par évaporation au rayon laser, par évaporation à l'arc électrique ou par épitaxie par faisceau moléculaire, ou (ii) par pulvérisation cathodique, par exemple par dépôt assisté d'un faisceau ionique, ou (iii) par placage ionique, ou (iv) par dépôt ICB (ionized cluster beam deposition, ICBD).

3. Procédé de fabrication du non-tissé (4) selon la revendication 1 ou 2, **caractérisé en ce que** les premières molécules d'alliage métallique à l'étape a) et/ou les deuxièmes molécules d'alliage métallique à l'étape c) sont refroidies par des moyens appropriés, de préférence par l'apport d'un gaz approprié, plus préférentiellement d'un gaz rare, avant d'être mises en contact avec le matériau polymère à l'étape d), avec la surface des fibres polymères à noyaux de fibre remplis à l'étape e) ou avec la surface du non-tissé (4) à l'étape f).

4. Procédé de fabrication du non-tissé (4) selon l'une des revendications précédentes, **caractérisé en ce que** le premier et le deuxième alliage métallique (3, 2) à l'étape a) et à l'étape c) sont sous forme de poudre, de préférence avec un diamètre de particule moyen de l'ordre de ≤ 100 µm, plus préférentiellement ≤ 50 µm, encore plus préférentiellement ≤ 20 µm.

5. Procédé de fabrication du non-tissé (4) selon l'une des revendications précédentes, **caractérisé en ce que** le matériau polymère est fourni à l'étape b) dans un dispositif qui fournit le matériau polymère à l'étape d) sous forme de gouttes pour l'introduction des premières molécules d'alliage métallique dans le matériau polymère, le dispositif étant de préférence commandé de manière piézoélectrique.

6. Procédé de fabrication du non-tissé (4) selon l'une des revendications précédentes, **caractérisé en ce que** les fibres polymères (1) à noyaux de fibre remplis sont fabriquées à l'étape d) par filage électrique, les fibres polymères (1) à noyaux de fibre remplis présentant de préférence un diamètre de particule moyen de ≤ 500 µm, plus préférentiellement de ≤ 100 µm, encore plus préférentiellement de ≤ 50 µm, encore plus préférentiellement de ≤ 1 µm.

7. Procédé de fabrication du non-tissé (4) selon l'une des revendications précédentes, **caractérisé en ce que** le premier alliage métallique (3) de l'étape a) et/ou le deuxième alliage métallique (2) de l'étape c) comprend un, deux, trois ou plusieurs alliages métalliques différents,
les métaux du ou des premiers alliages métalliques (3) de l'étape a) étant en particulier choisis parmi deux, trois, quatre ou plusieurs métaux du groupe constitué par le plomb (Pb), le titane (Ti), le paladium (Pd), le praséodyme (Pr), le lanthane (La), l'indium (In), le cobalt (Co), l'aluminium (Al), le chrome (Cr), le nickel (Ni), le molybdène (Mo), le baryum (Ba), l'yttrium (Y), le samarium (Sm), le silicium (Si), le germanium (Ge) et le fer (Fe),
les métaux du ou des deuxièmes alliages métalliques (2) de l'étape c) étant en particulier choisis parmi deux, trois, quatre ou plusieurs métaux du groupe constitué par le fer (Fe), le manganèse (Mn), le cuivre (Cu), le zinc (Zn), le tungstène (W), le silicium (Si), l'argent (Ag) et l'étain (Sn).

8. Procédé de fabrication du non-tissé (4) selon l'une des revendications précédentes, **caractérisé en ce que** les premiers alliages métalliques (3) de l'étape a) sont choisis dans le groupe constitué par des alliages de cobalt, par exemple Co_{68.7}Fe₄Ni₁B₁₃Si₁₁Mo_{2.3}, Nd₃Fe₆₈₋ₓMnₓCo₁₈B₁₁ (x = 0, 1, 2) ou CoFe₂ ; des alliages de paladium, de préférence des alliages paladium-indium-fer, par exemple Pd₅₇In₂₅Fe₁₈, et Pd_{56.2}In_{26.3}Fe_{17.5} ; de préférence des alliages de titane-paladium-fer, par exemple Ti₅₀Pd₄₀Fe₁₀, et Ti₅₀Pd₃₅Fe₁₅ ; de préférence des alliages de paladium-manganèse-indium, par exemple Pd₂MnIn ; des alliages d'indium-phosphate, par exemple InPO₃; des alliages de manganate, par exemple des alliages de praséodyme-lanthane-calcium-manganate, tels que des alliages de praséodyme-calcium-manganate ou des alliages de lanthane-calcium-manganate, tels que Pr_{0.7}Ca_{0.3}MnO₃ ou La_{0.7}Ca_{0.3}MnO₃ ; des alliages de néodyme-plomb-manganate tels que Nd_{0.5}Pb_{0.5}MnO₃, des alliages de lanthane-baryum-manganate tels que La_{2/3}Ba_{1/3}MnO₃ ; des alliages de bore-cuivre tels que B₂CuO₂ ; des alliages à haute teneur en tungstène tels que des alliages baryum-yttrium-cuivre-tungstène et des alliages cuivre-samarium-tungstène et des alliages de fer tels que FeNiMo, Fe₈₅Si_{3.5}Al_{5.5}Cr₆ et FeMnW-( P_{0,5}Ge_{0,1}Pb_{0,4}W_{0,2}), et/ou
les deuxièmes alliages métalliques (2) de l'étape c) étant choisis dans le groupe constitué par des alliages de manganèse, de préférence des alliages de nickel-manganèse-étain, par exemple Ni₂Mn_{1.44}Sn_{0.56}, et Ni₂Mn_{1.42}Sn_{0.58} ; de préférence des alliages de nickel-manganèse-gallium, par exemple Ni₂MnGa ; de préférence des alliages de fer-manganèse-silicium, par exemple FeMnSi, Fe_{57.4}Mn₃₅Si_{7.6}, Fe_{66.7}Mn_{28.8}Si_{6.5} et FeMnW-( P_{0,5}Ge_{0,1}Pb_{0,4}W_{0,2}) ; et des alliages d'argent-magnésium, par exemple Ag-MgF₂-Ag, et/ou
le premier et le deuxième alliage métallique (3, 2) de l'étape a) et de l'étape c) étant exempts d'oxygène.

9. Procédé de fabrication du non-tissé (4) selon l'une des revendications précédentes, **caractérisé en ce qu'**un ou plusieurs matériaux sont en outre fournis, lesquels améliorent la résistance à la température du non-tissé (4) et sont incorporés dans le mélange de molécules d'alliage métallique et de polymères à l'étape d),
le matériau améliorant la résistance à la température du matériau polymère étant en particulier choisi parmi les matériaux vitreux, en particulier le verre, la céramique et la porcelaine, et/ou les matériaux carbonés, en particulier le graphène,
le matériau améliorant la résistance à la température du matériau polymère étant en particulier incorporé sous forme de poudre dans le mélange de molécules d'alliage métallique et de polymère à l'étape d).

10. Procédé de fabrication du non-tissé (4) selon l'une des revendications précédentes, **caractérisé en ce que** le matériau polymère de l'étape b) est choisi dans la liste constituée par le groupe des polyesters, par exemple le polyéthylène téréphtalate (PET), et le groupe des polyamides, par exemple le poly(p-phénylène téréphtalamide) (PPTA) et le poly(m-phénylène isophtalamide) (PMPI).

11. Procédé de fabrication du non-tissé (4) selon l'une des revendications précédentes, **caractérisé en ce que** le non-tissé (4) fabriqué présente une épaisseur de couche de ≤ 1 mm, de préférence de ≤ 500 µm, plus préférentiellement de ≤ 200 µm.

12. Non-tissé (4) pour le blindage contre un rayonnement électromagnétique, apte à être fabriqué selon l'une des revendications 1 à 11.

13. Non-tissé (4) selon la revendication 12, **caractérisé en ce que** le non-tissé (4) présente, pour un rayonnement térahertz dans le domaine de 5 THz à 300 THz, une atténuation de blindage de ≥ 10 %, de préférence à 30 THz, une atténuation de blindage de ≥ 70 %, plus préférentiellement de ≥ 80 %, encore plus préférentiellement de ≥ 90 %, et/ou de préférence à 300 THz, une atténuation de blindage de ≥ 15 %, de préférence de ≥ 20 %, et/ou
le non-tissé présentant une valeur d'atténuation de ≥ 100 décibels (dB) pour un rayonnement terahertz dans le domaine de 5 THz à 300 THz, et/ou
le non-tissé (4) présentant 50 à 60 % en poids de matériau polymère, jusqu'à 50 % en poids, de préférence 10 à 40 % en poids, plus préférentiellement 15 à 35 % en poids de premier et deuxième alliage métallique et, le cas échéant, jusqu'à 25 % en poids, de préférence 10 à 20 % en poids de matériau pour l'amélioration de la stabilité en température, respectivement par rapport au poids total du non-tissé (4), et/ou
le non-tissé (4) présentant une valeur de rétraction jusqu'à 5 % selon la norme DIN 7715 partie 3 classe E3 et/ou une résistance superficielle de 4 à 7 ohms/pouce, de préférence de 5,5 ohms/pouce pour un courant d'essai de 20 mA dans l'axe X-Y-Z du non-tissé (4) et/ou étant résistant à la température dans la plage de - 40°C à + 120°C et/ou étant résistant à l'ozone et/ou présentant une capacité d'absorption d'eau ≤ 4% et/ou présentant un poids de ≤ 200 g/m², de préférence de ≤ 100 g/m².

14. Utilisation du non-tissé (4) selon l'une des revendications 12 ou 13 pour le blindage contre un rayonnement terahertz dans le domaine de 5 THz à 300 THz, et/ou
pour la fabrication de combinaisons de protection humaines ou animales, et/ou
pour le blindage de bâtiments, de véhicules (terrestres, maritimes et/ou aériens), d'objets et/ou de conduites, et/ou
pour la fabrication d'isolations polymères d'ouvertures dans des bâtiments ou des véhicules (terrestres, maritimes et/ou aériens) ou des objets ou des conduites.
